# EUROPEAN PATENT SPECIFICATION

(11) **EP 4 489 277 B1**
(45) Date of publication and mention of the grant of the patent: **25.11.2026**
(21) Application number: 24715702.7
(22) Date of filing: 18.02.2024
(51) Int. Cl.: H02M 7/44, H02M 1/32, H05K 7/20, G01R 31/69, H02J 1/102

(54) **POWER CONVERTER COMPRISING CONTROLLER FOR DETERMINING ABNORMAL TERMINAL OF THE POWER CONVERTER**
STROMWANDLER UMFASEND STEUEREINRICHTUNG ZUR BESTIMMUNG EINES ANORMALEN ANSCHLUSSES DES STROMWANDLERS
CONVERTISSEUR DE PUISSANCE COMPRENANT CONTRÔLEUR POUR DÉTERMINER UNE BORNE ANORMALE DU CONVERTISSEUR DE PUISSANCE

(30) Priority: 17.05.2023 CN 202310558778
(43) Date of publication of application: 08.01.2025
(73) Proprietor: Huawei Digital Power Technologies Co., Ltd., Shenzhen, Guangdong 518043 (CN)
(72) Inventor: YAN, Yang, Shenzhen, Guangdong 518043 (CN)
(74) Representative: Isarpatent
(86) International application number: PCT/CN2024/077461
(87) International publication number: WO 2024/234757

(56) References cited:
- EP-A1- 3 291 400
- WO-A1-2018/155848
- CN-A- 112 485 731
- CN-A- 115 411 703
- CN-A- 115 411 703
- CN-A- 115 987 214
- CN-A- 116 722 726
- JP-A- 2018 102 080
- JP-B2- 6 883 729
- US-A1- 2013 169 261
- US-A1- 20250 183 790

## Description

### TECHNICAL FIELD

This disclosure generally relates to the field of power conversion device safety.

The invention in particular relates to a power converter.

### BACKGROUND

As the environmental crisis and energy crisis become global problems, new energies, such as wind energy and solar energy, have naturally emerged as a key to improving an energy structure and solving energy problems. As an important part of a new energy power generation solution, power converters are developing rapidly toward high efficiency, reliability, and low costs.

The power converter includes an inverter, a converter, and the like, and is configured to perform direct current/direct current (DC/DC) conversion, direct current/alternating current (DC/AC) conversion, alternating current/direct current (AC/DC) conversion, or the like in various scenarios. Different quantities of direct current terminals configured to receive a current input by a pre-stage circuit may be disposed in the power converter based on a specific application scenario. In a process of using the direct current terminal, the direct current terminal may be in poor contact as a result of insecure inserting or loosening. Consequently, temperatures of some terminals keep increasing and the terminals work at a high temperature for a long time. In some extreme cases, the direct current terminals may be burnt. To avoid this situation, an abnormal terminal needs to be located in a manner such as temperature detection, and the abnormal terminal needs to be dealt with in a timely manner, to ensure continuous and stable operation of the power converter.

WO 2018/155848 A1 discloses an electrical fire prevention system of a solar photovoltaic power generation facility, and to an electrical fire prevention system of a solar photovoltaic power generation facility comprising: a unit solar photovoltaic string which includes at least one solar panel; a connection panel which collects solar photovoltaic power of the unit solar photovoltaic string; and an inverter which converts the solar photovoltaic power into commercial power, wherein the connection panel comprises: at least one connection electronic circuit board which implements a voltage and current sensing function, a reverse current prevention function, and a circuit protection function with respect to the solar photovoltaic power, measures the amount of power generated by the unit solar photovoltaic string, and determines whether or not the unit solar photovoltaic string is operating normally; a breaker which connects the solar photovoltaic power to the inverter; a plurality of connection terminals in which the connection electronic circuit board and the main solar photovoltaic power are connected, and which are installed between the solar panel and the connection electronic circuit board and between the connection electronic circuit board and the breaker, respectively; at least one connection failure detection sensor which detects heat generated at the connection terminal; and at least one connection failure display unit which integratedly manages the detection results of the plurality of connection failure detection sensors and displays the detected status of the connection failure of the connection terminal. Accordingly, the disclosure can prevent the occurrence of an arc or can suppress the occurrence of a fire due to the occurrence of an arc by forming a cut-out portion in the connection electronic circuit board or sufficiently ensuring a separation distance between (+)/(-) conductors through a separation disposition of (+)/(-) conductors, and the disclosure can detect and send notification of the connection failure at all the connection terminals through the connection failure detection sensor, which is a thermally sensitive element to prevent the fire of the connection panel, and as a result, the disclosure can minimize the economic loss, casualties and spreading of the fire caused by a fire of the connection panel.

CN 115 411 703 A discloses a power conversion device and a protection method thereof, wherein the power conversion device comprises a terminal board, an electric energy conversion circuit and a controller, the terminal board is provided with a first terminal and a first temperature sampling circuit, and the first terminal is connected with a DC power supply or the electric energy conversion circuit through a protection switch. The first temperature sampling circuit is used for collecting temperature parameters of the first terminal. The controller obtains the temperature parameter of the first terminal and controls the protection switch to be switched off under the condition that the temperature parameter of the first terminal is larger than a temperature parameter threshold value. According to the disclosure, the temperature of the terminal to be subjected to temperature measurement can be obtained in time, so that the over-temperature protection of the terminal can be realized in time when the temperature of the terminal to be subjected to temperature measurement is too high, and the reliable operation of the terminal of the power conversion equipment is ensured.

EP 3 291 400 A1 discloses a method for detecting, by a device, an increase in temperature at certain parts of an electrical system, and taking appropriate responsive action. The method may include measuring temperatures at certain locations within the system and estimating temperatures at other locations based on the measurements. Some embodiments disclosed herein include an integrated cable combining electrical conduction and heat-detection capabilities, or an integrated cable or connector combining electrical conduction with a thermal fuse.

US 2013/0169261 A1 discloses: A device for classifying electrical contacting between a first connecting element of a battery and a second connecting element, which is directly or indirectly connected to an electrical load. A temperature sensor is provided for detecting the temperature of the first connecting element and/or of the second connecting element and a control device, which is coupled to the temperature sensor and which is configured, on the basis of a detecting signal of the temperature sensor, to classify the electrical contacting between the first connecting element and the second connecting element. A corresponding method and to a battery system, as well as a battery receiving system including such a device for classifying electrical contacting. Moreover, there is provided an electrical power supply system with such a battery system and such a battery receiving system.

JP 6 883 729 B2 addresses the technical problem of the protection and efficient operation of power conversion systems that use multiple solar cell strings, each connected to its own DC/DC converter. For this purpose, a control unit is suggested that monitors electrical information on both the input side (for each DC/DC converter or solar string) and the output side (the common DC line). When an abnormality is detected on the input side for a specific string, only the DC/DC converter associated with that string is stopped, allowing the other strings to continue operating. On the other hand, if an abnormality is detected on the output side, such as the common DC line voltage, current, or temperature exceeding a threshold, all DC/DC converters are stopped to protect the system. In this way, there is provided a more selective and responsive protection scheme that improves both the safety and the efficiency of the solar power system by allowing continued operation of unaffected strings and ensuring a faster response to abnormal conditions.

### SUMMARY

The object of the present invention is to provide a power converter with means for determining an abnormal terminal of the power converter, to detect an abnormal terminal and locate the abnormal terminal in a timely manner, so that maintenance personnel perform a maintenance operation on the abnormal terminal of the power converter conveniently, and continuous and stable operation of the power converter is ensured. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

According to a first aspect according to the invention, the invention provides a power converter. The power converter includes a plurality of direct current terminals, a plurality of temperature detection units, a plurality of DC/DC (direct current/direct current) conversion circuits, at least one DC/AC (direct current/alternating current) conversion circuit, and a controller. Input ends of the plurality of direct current terminals are connected to a direct current source, output ends of the plurality of direct current terminals are correspondingly connected to input ends of the plurality of DC/DC conversion circuits, output ends of the plurality of DC/DC conversion circuits are correspondingly connected to an input end of the at least one DC/AC conversion circuit, and an output end of the at least one DC/AC conversion circuit is configured to connect to a load. The plurality of temperature detection units are configured to detect detected temperatures of the plurality of direct current terminals. The controller controls, in response to that a highest temperature value in the detected temperatures of the plurality of direct current terminals is greater than a first alarm threshold, a current value of an input current of at least one DC/DC conversion circuit in the plurality of DC/DC conversion circuits to decrease, and if the highest temperature value decreases to be less than or equal to a first safety threshold after the current value of the input current of the at least one DC/DC conversion circuit is decreased, outputs a signal indicating that the direct current terminal corresponding to the at least one DC/DC conversion circuit is abnormal, where the first safety threshold is less than or equal to the first alarm threshold. Alternatively, the controller controls, in response to that a highest temperature value in the detected temperatures of the plurality of direct current terminals is greater than a second alarm threshold, current values of input currents of all DC/DC conversion circuits in the plurality of DC/DC conversion circuits to decrease, then controls, in response to that the highest temperature value decreases to be less than or equal to a second safety threshold, the current value of the input current of at least one DC/DC conversion circuit in the plurality of DC/DC conversion circuits to increase, and if the highest temperature value increases to be greater than the second alarm threshold after the current value of the input current of the at least one DC/DC conversion circuit is increased, output a signal indicating that the direct current terminal corresponding to the at least one DC/DC conversion circuit is abnormal, where the second safety threshold is less than or equal to the second alarm threshold.

According to the invention, the temperature values of the plurality of terminals are detected, so that the highest temperature value of the plurality of terminals is obtained. When the highest temperature value exceeds the alarm threshold, it indicates that a temperature of at least one terminal is abnormal. A value of an input current corresponding to a specific terminal is controlled, to observe whether the highest temperature value changes, so that whether the terminal is an abnormal terminal may be determined. In this manner of searching for an abnormal terminal, temperature detection units (such as NTCs) with relatively low costs may be used to perform temperature detection. This effectively reduces use of a chip in the power converter and finds an abnormal terminal in a timely manner.

With reference to the first aspect, in a first implementation according to the invention, the power converter includes a fan, and the controlling, in response to that the highest temperature value in the detected temperatures of the plurality of direct current terminals is greater than the first alarm threshold, the current value of the input current of the at least one DC/DC conversion circuit in the plurality of DC/DC conversion circuits to decrease includes: controlling, in response to that the highest temperature value in the detected temperatures of the plurality of direct current terminals is greater than the first alarm threshold, a rotation speed of the fan to increase, so that the highest temperature value decreases to be less than the first alarm threshold, then controlling the rotation speed of the fan to decrease, and controlling, in response to that the highest temperature value returns to the first alarm threshold, the current value of the input current of the at least one DC/DC conversion circuit in the plurality of DC/DC conversion circuits to decrease.

According to the invention, the rotation speed of the fan is first increased to decrease a temperature of the abnormal terminal, so that the temperature of the abnormal terminal decreases to be less than the alarm threshold, and then the rotation speed of the fan is decreased, so that the temperature of the abnormal terminal is maintained as precisely as possible at the alarm threshold. In this case, when an input current of the abnormal direct current terminal is decreased, a decrease of the highest temperature value may be presented in a shorter time period. This reduces duration consumed in an abnormal terminal detection process.

With reference to the first aspect according to the invention, in a second implementation according to the invention, the power converter includes a fan, and the controlling, in response to that the highest temperature value in the detected temperatures of the plurality of direct current terminals is greater than the second alarm threshold, current values of input currents of all the DC/DC conversion circuits in the plurality of DC/DC conversion circuits to decrease includes: controlling, in response to that the highest temperature value in the detected temperatures of the plurality of direct current terminals is greater than the second alarm threshold, the current values of the input currents of all the DC/DC conversion circuits in the plurality of DC/DC conversion circuits to decrease, and controlling a rotation speed of the fan to increase.

According to the invention, when all the input current values are controlled to decrease, the rotation speed of the fan may alternatively be controlled to increase synchronously, so that the temperature of the abnormal terminal decreases rapidly, that is, the highest temperature value decreases to be less than the alarm threshold quickly. In this way, time consumed in the entire abnormal terminal detection process may also be reduced, so that the abnormal terminal is quickly located, and a risk is reduced.

With reference to a second implementation of the first aspect and in accordance with the invention, in a third possible implementation, the controlling, in response to that the highest temperature value decreases to be less than or equal to the second safety threshold, the current value of the input current of the at least one DC/DC conversion circuit in the plurality of DC/DC conversion circuits to increase includes: controlling, in response to that the highest temperature value decreases to be less than or equal to the second safety threshold, the rotation speed of the fan to decrease, and then controlling the current value of the input current of the at least one DC/DC conversion circuit in the plurality of DC/DC conversion circuits to increase.

It should be understood that, after the highest temperature value decreases to be less than or equal to the second safety threshold, the rotation speed of the fan is controlled to decrease, to reduce heat dissipation in an entire device, and then the current is increased, to perform abnormality determining logic, so that a temperature increase of the abnormal terminal can be observed more quickly. In this case, increasing a rotation speed of the fan may be returning the rotation speed to an original rotation speed.

With reference to any one of the first aspect to the third possible implementation of the first aspect, in a fourth possible implementation, the controlling a current value of an input current of at least one DC/DC conversion circuit in the plurality of DC/DC conversion circuits to decrease includes: sequentially controlling a current value of an input current of a DC/DC conversion circuit in the plurality of DC/DC conversion circuits to decrease until the highest temperature value decreases to be less than or equal to the first safety threshold after a current value of an input current of an n^{th} DC/DC conversion circuit in the plurality of DC/DC conversion circuits is controlled to decrease.

With reference to any one of the first aspect to the fourth possible implementation of the first aspect, in a fifth possible implementation, the controlling the current value of the input current of the at least one DC/DC conversion circuit in the plurality of DC/DC conversion circuits to increase includes: sequentially controlling a current value of an input current of a DC/DC conversion circuit in the plurality of DC/DC conversion circuits to increase until the highest temperature value increases to be greater than the second alarm threshold after a current value of an input current of an m^{th} DC/DC conversion circuit in the plurality of DC/DC conversion circuits is controlled to increase.

With reference to any one of the first aspect to the fifth possible implementation of the first aspect, in a sixth possible implementation, the controller is configured to: after outputting a signal indicating that the direct current terminal corresponding to one DC/DC conversion circuit in the plurality of DC/DC conversion circuits is abnormal, control a current value of an input current of the one DC/DC conversion circuit to decrease.

According to a second aspect, wherein this second aspect and any implementations and options of this second aspect listed below are not claimed, this disclosure also describes a grid power supply system. The grid power supply system includes a power supply and the power converter according to any one of the first aspect and the possible implementations of the first aspect. The power supply is configured to provide a direct current voltage input for the power converter. The power converter is configured to perform direct current inverse conversion based on the direct current voltage provided by the power supply, and output an alternating current voltage to a load.

According to a third aspect, wherein this third aspect and any implementations and options of this third aspect listed below are not claimed, this disclosure also describes a method for determining an abnormal terminal of a power converter. The method is applied to a power converter that includes a plurality of direct current terminals, a plurality of temperature detection units, a plurality of DC/DC (direct current/direct current) conversion circuits, and at least one DC/AC (direct current/alternating current) conversion circuit, where input ends of the plurality of direct current terminals are connected to a direct current source, output ends of the plurality of direct current terminals are correspondingly connected to input ends of the plurality of DC/DC conversion circuits, output ends of the plurality of DC/DC conversion circuits are correspondingly connected to an input end of the at least one DC/AC conversion circuit, and an output end of the at least one DC/AC conversion circuit is configured to connect to a load. The plurality of temperature detection units are configured to detect detected temperatures of the plurality of direct current terminals. The method includes: controlling, when a highest temperature value in the detected temperatures of the plurality of direct current terminals is greater than a first alarm threshold, a current value of an input current of at least one DC/DC conversion circuit in the plurality of DC/DC conversion circuits to decrease, and if the highest temperature value decreases to be less than or equal to a first safety threshold after the current value of the input current of the at least one DC/DC conversion circuit is decreased, outputting a signal indicating that the direct current terminal corresponding to the at least one DC/DC conversion circuit is abnormal, where the first safety threshold is less than or equal to the first alarm threshold; or controlling, when a highest temperature value in the detected temperatures of the plurality of direct current terminals is greater than a second alarm threshold, current values of input currents of all DC/DC conversion circuits in the plurality of DC/DC conversion circuits to decrease, and controlling, when the highest temperature value decreases to be less than or equal to the second safety threshold, a current value of an input current of at least one DC/DC conversion circuit in the plurality of DC/DC conversion circuits to increase, and if the highest temperature value increases to be greater than the second alarm threshold after the current value of the input current of the at least one DC/DC conversion circuit is increased, outputting a signal indicating that the direct current terminal corresponding to the at least one DC/DC conversion circuit is abnormal, where the second safety threshold is less than or equal to the second alarm threshold.

With reference to the third aspect, in a first possible implementation, the power converter includes a fan. In the method, the controlling, when a highest temperature value in the detected temperatures of the plurality of direct current terminals is greater than a first alarm threshold, a current value of an input current of at least one DC/DC conversion circuit in the plurality of DC/DC conversion circuits to decrease includes: controlling, when the highest temperature value in the detected temperatures of the plurality of direct current terminals is greater than the first alarm threshold, a rotation speed of the fan to increase, so that the highest temperature value decreases to be less than the first alarm threshold, then controlling the rotation speed of the fan to decrease, and controlling, when the highest temperature value returns to the first alarm threshold, the current value of the input current of the at least one DC/DC conversion circuit in the plurality of DC/DC conversion circuits to decrease.

With reference to the third aspect, in a second possible implementation, the power converter includes a fan. In the method, the controlling, when a highest temperature value in the detected temperatures of the plurality of direct current terminals is greater than a second alarm threshold, current values of input currents of all DC/DC conversion circuits in the plurality of DC/DC conversion circuits to decrease includes: controlling, when the highest temperature value in the detected temperatures of the plurality of direct current terminals is greater than the second alarm threshold, the current values of the input currents of all the DC/DC conversion circuits in the plurality of DC/DC conversion circuits to decrease, and controlling a rotation speed of the fan to increase.

With reference to the first possible implementation of the third aspect, in a third possible implementation, in the method, the controlling, when the highest temperature value decreases to be less than or equal to the second safety threshold, a current value of an input current of at least one DC/DC conversion circuit in the plurality of DC/DC conversion circuits to increase includes: controlling, when the highest temperature value decreases to be less than or equal to the second safety threshold, the rotation speed of the fan to decrease, and then controlling the current value of the input current of the at least one DC/DC conversion circuit in the plurality of DC/DC conversion circuits to increase.

With reference to the third aspect to the third possible implementation of the third aspect, in a fourth possible implementation, in the method, the controlling a current value of an input current of at least one DC/DC conversion circuit in the plurality of DC/DC conversion circuits to decrease includes: sequentially controlling a current value of an input current of a DC/DC conversion circuit in the plurality of DC/DC conversion circuits to decrease until the highest temperature value decreases to be less than or equal to the first safety threshold after a current value of an input current of an n^{th} DC/DC conversion circuit in the plurality of DC/DC conversion circuits is controlled to decrease.

With reference to the third aspect to the fourth possible implementation of the third aspect, in a fifth possible implementation, in the method, the controlling the current value of the input current of the at least one DC/DC conversion circuit in the plurality of DC/DC conversion circuits to increase includes: sequentially controlling a current value of an input current of a DC/DC conversion circuit in the plurality of DC/DC conversion circuits to increase until the highest temperature value increases to be greater than the second alarm threshold after a current value of an input current of an m^{th} DC/DC conversion circuit in the plurality of DC/DC conversion circuits is controlled to increase.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

FIG. 1 is a schematic diagram of an application scenario of a power converter according to an embodiment of this application;
FIG. 2 is a schematic diagram of a structure of a power converter according to an embodiment of this application;
FIG. 3 is a schematic diagram of a structure of a power converter according to an embodiment of this application;
FIG. 4 is a schematic diagram of a structure of a power converter according to an embodiment of this application;
FIG. 5 is a schematic top view of a power converter according to an embodiment of this application;
FIG. 6 is a schematic front view of a power converter according to an embodiment of this application;
FIG. 7 is a schematic diagram of a grid power supply system according to an embodiment of this application;
FIG. 8 is a schematic flowchart of determining of an abnormal terminal of a power converter according to an embodiment of this application;
FIG. 9 is a schematic flowchart of determining of an abnormal terminal of a power converter according to an embodiment of this application;
FIG. 10 is a schematic flowchart of determining of an abnormal terminal of a power converter according to an embodiment of this application;
FIG. 11 is a schematic flowchart of determining of an abnormal terminal of a power converter according to an embodiment of this application;
FIG. 12 is a schematic diagram of an abnormal terminal detection circuit of a power converter according to an embodiment of this application;
FIG. 13 is a schematic diagram of an abnormal terminal detection circuit of a power converter according to an embodiment of this application;
FIG. 14 is a schematic diagram of an abnormal terminal detection circuit of a power converter according to an embodiment of this application; and
FIG. 15 is a schematic diagram of a structure of a circuit of a power converter according to an embodiment of this application.

### DESCRIPTION OF EMBODIMENTS

The photovoltaic inverter and the photovoltaic system provided in this application are applicable to various application scenarios such as a field of new energy power generation, a field of peak regulation and frequency regulation of conventional power generation, and a field of power supply of important devices. This may be specifically determined based on an actual application scenario, and is not limited herein. The photovoltaic inverter and the photovoltaic system provided in this application are applicable to different scenarios such as a large photovoltaic power station, industrial and commercial photovoltaic power generation, and household photovoltaic power generation. This is not limited herein. The following uses an application scenario in which an inverter in a photovoltaic power supply environment is controlled as an example for description. Details are not described in the following again.

According to the technical solution provided in embodiments of this application, an abnormal direct current terminal of a power converter can be quickly responded to, and the abnormal terminal can be quickly located, so that maintenance personnel perform a subsequent maintenance operation on the abnormal terminal conveniently. It should be understood that the power converter in this application includes power converters configured to perform direct current/direct current conversion, direct current/alternating current conversion, and alternating current/direct current conversion in various scenarios, such as an inverter and a converter, and the like. For ease of description, in embodiments of this application, the technical solution of this application is described by using an application scenario of a photovoltaic inverter as an example. Details are not described in the following again.

For ease of understanding, terms in embodiments of this application are first explained.

PV means a polar photovoltaic panel.

Direct current terminal means a terminal that is in a photovoltaic inverter and that is configured to receive a direct current input of a PV or a direct current input of an energy storage apparatus.

NTC means a negative temperature coefficient thermistor.

Connection should be understood in a broad sense. For example, if A is connected to B, A may be directly connected to B, or A and B can be indirectly connected through an intermediate medium.

The following clearly describes specific implementations of this application with reference to the accompanying drawings.

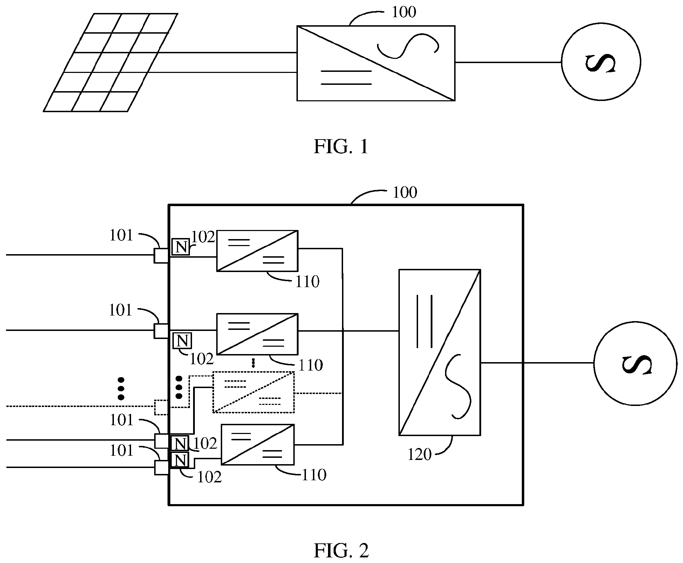

An application scenario in which a photovoltaic power generation system is directly connected to a grid is used. As shown in FIG. 1, a power supply of a power converter 100 is a PV. The PV may convert solar energy into electric energy, and output a direct current to the power converter 100. The power converter 100 performs, based on the direct current provided by the PV, corresponding power conversion generally including DC/DC conversion and DC/AC conversion, to convert the input direct current into an alternating current, and output the alternating current to a load. The load may be a grid, or may be a home electric device.

It should be understood that, in actual application, before the direct current output by the PV is input to the power converter, the direct current may further pass through one DC/DC unit, so that a voltage and a frequency of the direct current received by the power converter 100 are within an adaptation range of the power converter 100. Because a setting of the DC/DC unit is not directly related to the technical solution provided in this application, details are not described in embodiments of this application.

For a power converter provided in this embodiment of this application, refer to FIG. 2 in the accompanying drawings of this specification. A power converter 100 includes a plurality of direct current terminals 101 configured to receive a direct current input by a direct current source, for example, a PV. Each direct current terminal 101 has a corresponding DC/DC conversion circuit 110. The DC/DC conversion circuit 110 may perform direct current voltage conversion on the direct current input by the direct current terminal 101, and then input direct current on which the direct current voltage conversion is performed to a DC/AC conversion circuit 120. The DC/AC conversion circuit 120 may convert a direct current received from the DC/DC conversion circuit 110 into an alternating current required by an external load, so that an entire power supply system supplies power to the load. Because the direct current terminal 101 is generally mechanically connected by using a conducting wire led from the PV side manually, the terminal may be loose as a result of an error during manual installation, an accidental collision, or the like. A loose direct current terminal 101 accompanied by a large current input may cause a temperature of the direct current terminal 101 to increase and consequently damage the direct current terminal 101 or even the entire power converter 100. Therefore, the temperature detection unit 102 needs to be configured to perform temperature detection on the direct current terminal 101 of the power converter 100. When the direct current terminal 101 is abnormal, a current value of an input current of the DC/DC conversion circuit 110 is adjusted in a timely manner, so that the temperature of the direct current terminal 101 decreases.

In this embodiment provided in this application, a plurality of temperature detection units 102 may use NTCs with relatively low costs (for example, surface mount NTCs). The NTCs may perform temperature detection on direct current terminals 101 corresponding to the NTCs, to obtain a plurality of pieces of temperature data. The NTCs can transfer only temperature data, and cannot transfer information about which specific direct current terminal 101 corresponds to a piece of temperature data. Therefore, whether a direct current terminal in the plurality of direct current terminals 101 of the power converter 100 is abnormal may be determined based on a highest temperature value in the plurality of pieces of temperature data, and then each direct current terminal 101 is screened step by step. The highest temperature value may be obtained by using a competition circuit. Because the competition circuit is a common means used by a person skilled in the art to obtain a largest value of data in a data group, details are not described herein again.

In a possible implementation, a first alarm threshold may first be preset, and the first alarm threshold may be obtained by performing related production compliance testing on the power converter 100. When the highest temperature value in the plurality of pieces of temperature data exceeds the first alarm threshold, it indicates that a direct current terminal in the plurality of direct current terminals 101 is abnormal. The abnormal terminal may have a problem of not being securely inserted during manual inserting, or the abnormal terminal may have a problem of being loose as a result of collision with an external object or an excessively long use time, or a temperature of the terminal is abnormal as a result of electrical aging of the terminal.

It may be understood that, if an input current of a DC/DC conversion circuit 110 corresponding to a normal direct current terminal 101 is decreased after the highest temperature value exceeds the first alarm threshold, although a temperature value of the direct current terminal 101 may decrease, because the temperature of the normal direct current terminal 101 is not the highest temperature value, the highest temperature value in the temperature data presented by the plurality of temperature detection units 102 does not change. Similarly, if the highest temperature value decreases to some extent after current values of input currents of DC/DC conversion circuits 110 corresponding to a specific or several direct current terminals 101 are decreased after the highest temperature value exceeds the first alarm threshold, it may be determined that there is an abnormal terminal in the one or more direct current terminals 101. It may be further understood that, if the highest temperature value does not change after current values of input currents of a plurality of DC/DC conversion circuits 110 are decreased, it indicates that direct current terminals 101 corresponding to the plurality of DC/DC conversion circuits 110 are normal. On the contrary, if the highest temperature value decreases after current values of input currents of a plurality of DC/DC conversion circuits 110 are decreased, it indicates that a range of the abnormal terminal is within a range of direct current terminals 101 corresponding to the plurality of DC/DC conversion circuits 110. It should be noted that, the degree to which the highest temperature value decreases herein may be decreasing to be less than or equal to the first safety threshold. When the highest temperature value decreases to be less than or equal to the first safety threshold, it may be considered that a direct current terminal 101 corresponding to the DC/DC conversion circuit 110 whose current value of the input current is decreased is abnormal.

It may be understood that, it also takes a specific period of time for a temperature of the direct current terminal 101 to decrease. Therefore, a period of time for observation is required. If the corresponding direct current terminal 101 is a unique abnormal terminal, after long enough observation time, the highest temperature value decreases, so that it can be determined that the terminal is abnormal. However, if the observation time is excessively short, the temperature of the terminal may not completely decrease, which may cause a specific probability of misjudgment. However, setting excessively long observation time for accurate determining cannot be performed. If the observation time is excessively long, when the terminal is a non-abnormal terminal, excessive time is wasted. As a result, a pace of obtaining the abnormal terminal through screening is very slow, and time for checking for an abnormal terminal is prolonged. Therefore, a first time threshold may be set based on a safety assurance requirement of an application scenario of the power converter 100 and experimental data and serve as the observation time for the highest temperature value after the current value of the input current is decreased. If the highest temperature value decreases to be less than or equal to the first safety threshold within the first time threshold, it is considered that the direct current terminal 101 corresponding to the DC/DC conversion circuit 110 whose current value of the input current is decreased is the abnormal terminal. If the highest temperature value does not decrease to be less than or equal to the first safety threshold after the first time threshold, the direct current terminal 101 corresponding to the DC/DC conversion circuit 110 is very likely not the abnormal terminal, and an abnormal terminal determining process may be stopped, and abnormality detection determining logic is performed on direct current terminal 101 corresponding to another DC/DC conversion circuits 110. The first safety threshold herein may also be set in advance based on corresponding production compliance experimental testing data. It may be understood that the value varies based on specific structures and use environments of different power converters. This is not specifically limited in this embodiment of this application. The first safety threshold may be less than or equal to the first alarm threshold.

In another possible implementation, when the highest temperature value in the temperature data of the plurality of direct current terminals 101 detected by the NTCs exceeds a specific value, current values of input currents of all the DC/DC conversion circuits 110 may be first decreased. In this way, the currents borne by all the direct current terminals 101 may be first decreased, so that temperatures of both the abnormal and non-abnormal terminals correspondingly decrease, so that device safety of the power converter 100 is ensured as soon as possible. The specific value herein may be a second alarm threshold. It may be understood that, within a period of time after current values of input currents of all the DC/DC conversion circuits 110 are decreased, a highest temperature value gradually decreases. After the highest temperature value decreases to a specific value, it may be considered that temperatures of all the direct current terminals 101 are in a safe state. In this case, a value may be set as a second safety threshold, that is, if the highest temperature value decreases to be less than or equal to the second safety threshold, the temperatures of all the direct current terminals 101 are in the safe state. In this case, if the highest temperature value increases to be greater than the second alarm threshold within a second time threshold existing after a current value of an input current of a specific DC/DC conversion circuit 110 is increased, it indicates that a direct current terminal 101 corresponding to the DC/DC conversion circuit 110 is abnormal, where the second safety threshold may be less than or equal to the second alarm threshold.

It should be noted that, in the foregoing two implementations, because policies for searching for the abnormal terminal are different, occasions and manners of decreasing the input current are also different, and duration in which the highest temperature value is at a high level may also be different. Therefore, values of the first safety thresholds, the second safety thresholds, the first alarm thresholds, the second alarm thresholds, the first time thresholds, and the second time thresholds may be different, and set specific values may alternatively be determined based on a corresponding production compliance requirement and an experimental detection result. This is not specifically limited in this embodiment of this application.

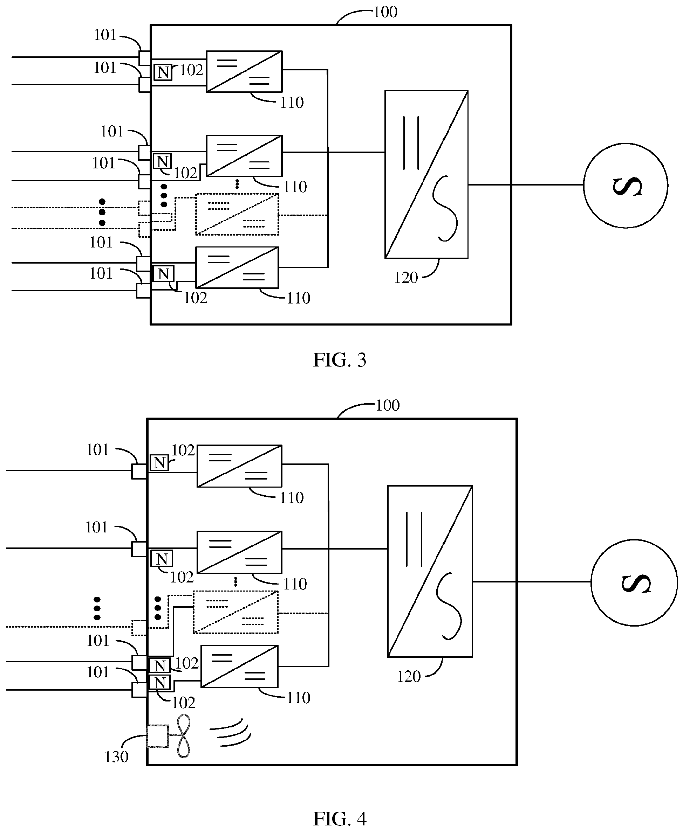

It should be understood that one DC/DC conversion circuit 110 in the power converter 100 may correspond to one temperature detection unit 102 and one direct current terminal 101, as shown in FIG. 2 in the accompanying drawings of this specification. In a specific design of the power converter, a case in which two direct current input terminals 101 correspond to one DC/DC conversion circuit 110 may exist. In this case, a current value of an input current of a DC/DC conversion circuit 110 is controlled to decrease, and input currents borne by two direct current terminals 101 are adjusted simultaneously, that is, temperature values of the two direct current terminals 101 are adjusted simultaneously. In this case, the temperature detection unit 102 may be directly disposed between the two direct current terminals 101 corresponding to the same DC/DC conversion circuit 110, to simultaneously detect the temperature values of the two direct current terminals 101 (certainly, one direct current terminal 101 may alternatively correspond to one temperature detection unit 102, and this is not specifically limited in embodiments of this application). For this design, refer to FIG. 3 in the accompanying drawings of this specification. In this case, the foregoing two implementations are used to check for the abnormal terminal, and a final checking result is two direct current terminals 101 that may be abnormal, where at least one of the two direct current terminals 101 is abnormal. Similarly, the DC/DC conversion circuit 110 may alternatively correspond to inputs of three or more direct current terminals 101, and a location in which the temperature detection unit 102 is disposed may alternatively be flexibly adjusted. Principles of checking for the abnormal terminal are similar, but granularities of checking are different. This is not specifically limited in this embodiment of this application.

Refer to FIG. 4 in the accompanying drawings of this specification. A power converter 100 provided in this embodiment of this application may include a fan 130. There may be one or more fans 130. This is not specifically limited in this embodiment of this application. The fan 130 may dissipate heat for a power device in the power converter 100 in a process in which the power converter 100 operates normally. When a highest temperature value in temperature data detected by NTCs exceeds a first alarm threshold or a second alarm threshold, the fan 130 may be collaboratively controlled, to increase or decrease a rotation speed, to adjust a heat dissipation speed inside the power converter 100, and adjust a temperature change speed of a direct current terminal 101. The fan 130 may form forced convection between air in the power converter 100 and external air, so that a temperature in the power converter 100 may decrease more quickly, so that a temperature of another part of the power converter 100 decreases accordingly. It should be understood that, rotation of the fan 130 consumes specific electric energy. Therefore, the rotation speed of the fan 130 may be changed flexibly based on factors such as a temperature of the power converter 100, a weather condition, and an ambient temperature, so that the fan 130 achieves a best heat dissipation effect under a most economic condition. Correspondingly, the highest temperature value may also be used as a reference factor for setting the rotation speed of the fan 130. When the controller knows that the highest temperature threshold reaches an alarm threshold, the controller may control the rotation speed of the fan 130 to change, so that the highest temperature value changes and falls within an expected range. Then, a current value of an input current is adjusted, to analyze a change of the highest temperature value, to output a determining result of an abnormal terminal.

In a possible implementation, when the highest temperature value exceeds the first alarm threshold, the rotation speed of the fan 130 may be first controlled to increase, so that the highest temperature value first decreases to be less than the first alarm threshold. In this way, the highest temperature value of the direct current terminals 101 may first decrease to be less than the first alarm threshold, and then a subsequent abnormal terminal detection policy is executed.

Further, after the highest temperature value decreases to be less than the first alarm threshold, a rotation speed of the fan 130 may be decreased, so that the highest temperature value increases to the first alarm threshold. When the highest temperature value increases to the first alarm threshold again, a current value of an input current of the DC/DC conversion circuit is controlled to change. If the highest temperature value decreases to be less than or equal to the first safety threshold within a first time threshold existing after the current value of the input current of the DC/DC conversion circuit is decreased, it indicates that a direct current terminal 101 corresponding to the DC/DC conversion circuit is abnormal. In this implementation, a heat dissipation capability of the fan 130 and heat generated by the abnormal terminal remain in an almost balanced state, that is, a temperature of the abnormal terminal is maintained as precisely as possible at the first alarm threshold. In this way, when the current value of the input current of the DC/DC conversion circuit 110 is decreased subsequently, if the input current corresponds to one abnormal terminal, a decrease of the highest temperature value may be observed more quickly, so that time for determining the abnormal terminal may be reduced, and efficiency of filtering abnormal terminals is improved. Therefore, in an actual application, like the first time threshold is set in the foregoing embodiment, a second time threshold may be set. Because a temperature of the abnormal terminal generally decreases in response to a decrease of a current value of an input current of a DC/DC conversion circuit 110 at a faster speed when the current heat dissipation capability of the fan 130 and heat generated by the direct current terminals 101 are in a relatively balanced state, the second time threshold may be smaller than the first time threshold. However, setting of the second time threshold certainly needs to be based on a comprehensive consideration of a use environment of the power converter 100, a specific design in terms of power and structure, and experimental testing. This is not limited in this embodiment of this application.

In another possible implementation, when the highest temperature value is greater than the second alarm threshold, current values of input currents of all the DC/DC conversion circuits 110 may be decreased, and the rotation speed of the fan 130 is controlled to increase, so that the highest temperature value decreases more quickly to be less than or equal to the second safety threshold. In this way, temperatures of all direct current terminals 101 may decrease, and because the rotation speed of the fan 130 increases, the temperatures of the direct current terminals 101 decrease more quickly, so that all the direct current terminals 101 enter a relatively safe state more quickly. This better guarantees safety of the direct current terminals 101 and the entire power converter 100.

Further, after the highest temperature value decreases to be less than or equal to the second safety threshold, the rotation speed of the fan 130 may be decreased, to reduce power consumption of the fan 130. In this case, all the direct current terminals 101 are in a safe state at a relatively low temperature. In this case, a current value of an input current of any one of all the DC/DC conversion circuits 110 is controlled to increase, and if the highest temperature value increases to be greater than the second alarm threshold within the second time threshold existing after the current value of the input current of the DC/DC conversion circuit 110 is increased, it indicates that a direct current terminal 101 corresponding to the DC/DC conversion circuit 110 is abnormal.

Specifically, when a current value of an input current of at least one DC/DC conversion circuit 110 is controlled to decrease after the highest temperature value in the temperatures of the plurality of direct current terminals 101 is greater than the first alarm threshold, a current value of an input current of a DC/DC conversion circuit 110 in the plurality of DC/DC conversion circuits 110 may be decreased sequentially (similarly, the rotation speed of the fan 130 may alternatively be first increased previously, so that the highest temperature value decreases to be less than the first alarm threshold, and then a rotation speed of the fan 130 is decreased, so that the highest temperature value returns to the first alarm threshold, and in this case, a heat dissipation capability of the fan 130 and heat generated by the direct current terminals 101 are in a nearly balanced state). For example, the power converter 100 includes a plurality of DC/DC conversion circuits 110 in total, and a current value of an input current of a first DC/DC conversion circuit 110 is first decreased. If a highest temperature value does not change within the first time threshold existing after the current value of the input current of the first DC/DC conversion circuit 110 is decreased, a current value of an input current of a second DC/DC conversion circuit 110 is decreased, and so on, until the highest temperature value decreases to be less than or equal to the first safety threshold within the first time threshold existing after a current value of an input current of an n^{th} DC/DC conversion circuit 110 is decreased. In this case, it indicates that a direct current terminal 101 corresponding to the n^{th} DC/DC conversion circuit is abnormal. Observation time for the highest temperature value after a previous current value is decreased is required between decreasing of current values of input currents of two DC/DC conversion circuits 110. Therefore, an interval between two times of decreasing a current value needs to be greater than or equal to the preset first time threshold, that is, a time interval between decreasing a current value of an input current of a q^{th} DC/DC conversion circuit 110 and decreasing a current value of an input current of a (q + 1)^{th} DC/DC conversion circuit 110 is greater than or equal to the first time threshold, where 1 ≤ q ≤ n - 1, and q is an integer.

In another possible specific embodiment, when the current value of the input current of the at least one DC/DC conversion circuit 110 is controlled to decrease after the highest temperature value in the temperatures of the plurality of direct current terminals 101 is greater than the second alarm threshold, the current values of the input currents of all the DC/DC conversion circuits 110 in the power converter 100 may be decreased, so that the highest temperature value decreases to be less than or equal to the second safety threshold (in this process, the rotation speed of the fan 130 may be increased synchronously to implement a rapid decrease of the highest temperature value, and the rotation speed of the fan 130 may be decreased subsequently to reduce power consumption, as described in the foregoing embodiment), and then current values of input currents of a plurality of DC/DC conversion circuits 110 are increased sequentially until the highest temperature value increases to be greater than the second alarm threshold within the second time threshold existing after a current value of an input current of a specific DC/DC conversion circuit 110 is increased, which indicates that a direct current terminal 101 corresponding to the DC/DC conversion circuit 110 is abnormal. For example, the power converter 100 includes a plurality of DC/DC conversion circuits 110 in total, and a current value of an input current of a first DC/DC conversion circuit 110 is first increased. If a highest temperature value does not change within the second time threshold existing after the current value of the input current of the first DC/DC conversion circuit 110 is increased, a current value of an input current of a second DC/DC conversion circuit 110 is increased, and so on, until the highest temperature value decreases to be less than or equal to the second safety threshold within the second time threshold existing after a current value of an input current of an m^{th} DC/DC conversion circuit 110 is increased, which indicates that a direct current terminal 101 corresponding to the m^{th} DC/DC conversion circuit is abnormal. Observation time for the highest temperature value after a previous current value is increased is required between increasing of current values of input currents of two DC/DC conversion circuits 110. Therefore, an interval between two times of increasing the current value needs to be greater than or equal to the preset second time threshold, that is, a time interval between increasing a current value of an input current of a p^{th} DC/DC conversion circuit 110 and increasing a current value of an input current of a (p + 1)^{th} DC/DC conversion circuit 110 is greater than or equal to the second time threshold, where 1 ≤ p ≤ n - 1, and p is an integer.

Further, after a location of the abnormal terminal is determined by using the foregoing embodiment, a current value of an input current of a DC/DC conversion circuit 110 corresponding to the abnormal terminal may be controlled to decrease or further decrease even to 0, to protect safety of the direct current terminals 101 and the power converter 100.

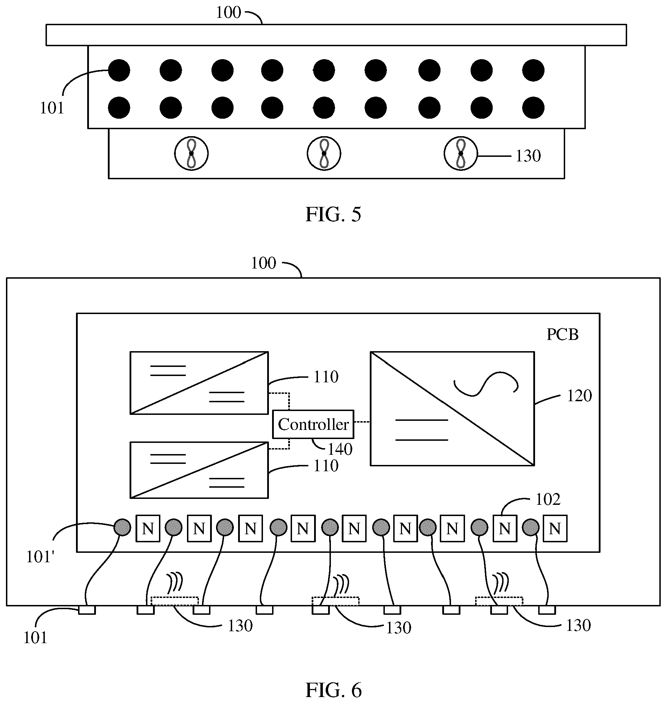

It should be noted that the foregoing determining logic of the power converter 100 needs to be completed by using one controller. FIG. 5 and FIG. 6 in the accompanying drawings of this specification are respectively a schematic top view and a schematic front view of a power converter 100 according to an embodiment of this application. Each direct current terminal 101 is at a bottom of a power converter 100, and is configured to connect to a direct current cable led from a direct current source. Several fans 130 are respectively disposed at locations adjacent to the direct current terminals 101, and are configured to blow air into a cavity of the power converter 100 to form convection to implement heat dissipation. The direct current terminal 101 also has a corresponding cable inside the power converter 100, and the cable connects the terminal to a corresponding terminal 101' on a PCB (Printed Circuit Board, printed circuit board). A circuit inside the PCB may connect a connection point 101' that corresponds to the direct current terminal 101 and that is on the PCB to an input end of the DC/DC conversion circuit 110, or may connect the DC/DC conversion circuit to a DC/AC conversion circuit, and working states of the DC/DC conversion circuit 110 and the DC/AC conversion circuit 120 are controlled by a controller 140 that is communicatively connected to the DC/DC conversion circuit 110 and the DC/AC conversion circuit 120. Abnormal terminal determining logic in the foregoing embodiment may be implemented through controlling by the controller 140. After a corresponding location of the abnormal terminal is obtained through screening, the controller 140 may send a signal indicating that a direct current terminal 101 corresponding to a specific DC/DC conversion circuit 110 is abnormal.

It should be noted that, quantities, locations, and connection relationships of units and components, such as the DC/DC conversion circuit 110, the DC/AC conversion circuit 120, the fan 130, and the direct current terminal 101, in the power conversion circuit 100 described in the accompanying drawings of this specification and embodiments of this application are merely possible examples, and are not intended to limit a structure of the power converter 100 in this application.

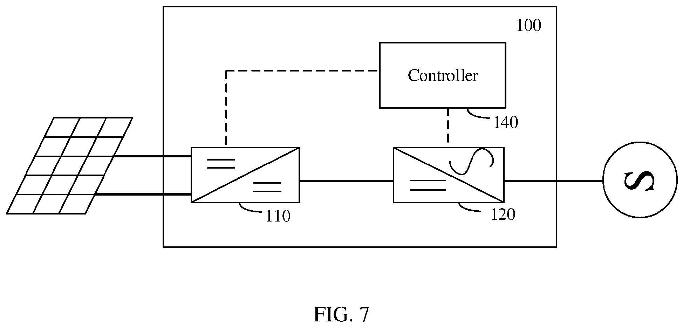

An embodiment of this application further provides a grid power supply system. For an architecture of the grid power supply system, refer to FIG. 7. The grid power supply system includes a power supply (for example a PV) and any power converter 100 in the foregoing embodiments. The power supply may provide direct current voltage input for the power converter 100. The power converter 100 is configured to perform direct current inverse conversion based on the direct current voltage provided by the power supply, and output an alternating current voltage to a load.

Based on a same inventive concept, an embodiment of this application further provides a method for determining an abnormal terminal of a power converter. The method is applied to a power converter, and the power converter (which may be the power converter 100 shown in FIG. 2 or the power converter 100 shown in FIG. 3 in the accompanying drawings of this specification) includes a plurality of direct current terminals 101, a plurality of temperature detection units 102, and a plurality of DC/DC (direct current/direct current) conversion circuits 110 and at least one DC/AC (direct current/alternating current) conversion circuit 120. Input ends of the plurality of direct current terminals 101 are connected to a direct current source, output ends of the plurality of direct current terminals 101 are correspondingly connected to input ends of the plurality of DC/DC conversion circuits 110, and output ends of the plurality of DC/DC conversion circuits 110 are correspondingly connected to an input end of one (or two or more, which is not limited in this embodiment of this application) DC/AC conversion circuit 120. An output end of the DC/AC conversion circuit 120 is configured to connect to a load. The temperature detection unit 102 is configured to detect a temperature of the direct current terminal 101.

In a possible implementation provided in this embodiment of this application, the method includes the following steps.

When a highest temperature value in temperatures of the plurality of direct current terminals 101 is greater than a first alarm threshold, step S101 is performed.

Step S101: Control a current value of an input current of at least one DC/DC conversion circuit in the plurality of DC/DC conversion circuits to decrease.

If the highest temperature value decreases to be less than or equal to a first safety threshold after the current value of the input current of the at least one DC/DC conversion circuit is decreased, step S102 is performed.

Step S102: Output a signal indicating that the direct current terminal corresponding to the at least one DC/DC conversion circuit is abnormal.

The first safety threshold is less than or equal to the first alarm threshold.

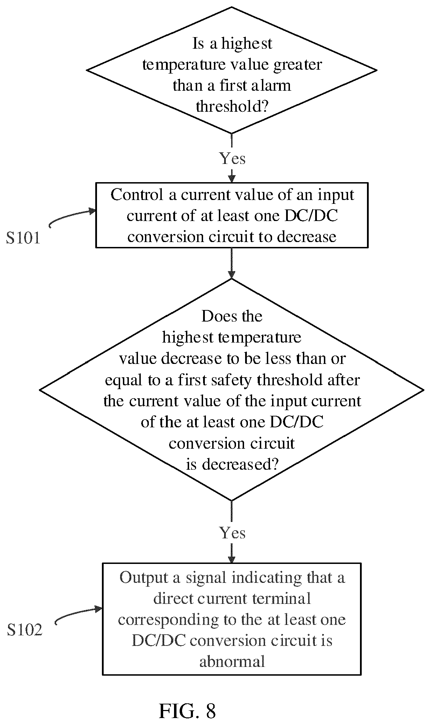

For a process of performing the method in the foregoing embodiment, refer to FIG. 8 in the accompanying drawings of this specification.

In another possible implementation provided in this embodiment of this application, the method includes the following steps.

When a highest temperature value is greater than a first alarm threshold, step S201 is performed.

Step S201: Sequentially control current values of input currents of the plurality of DC/DC conversion circuits to decrease.

If the highest temperature value decreases to be less than or equal to a first safety threshold after a current value of an input current of an n^{th} DC/DC conversion circuit is controlled to decrease, step S202 is performed.

Step S202: Output a signal indicating that the direct current terminal corresponding to the n^{th} DC/DC conversion circuit is abnormal.

It should be noted that, after the signal indicating that the direct current terminal corresponding to the n^{th} DC/DC conversion circuit is abnormal is output, abnormal terminal detection logic may continue to be performed on another direct current terminal, or may be stopped. This is not specifically limited in this embodiment of this application.

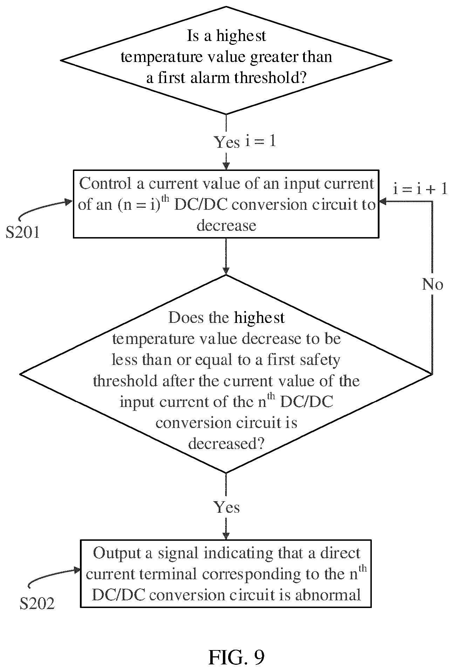

For a process of performing the method in the foregoing embodiment, refer to FIG. 9 in the accompanying drawings of this specification.

In another possible implementation provided in this embodiment of this application, the method includes the following steps.

When a highest temperature value is greater than a second alarm threshold, step S301 is performed.

Step S301: Control current values of input currents of all DC/DC conversion circuits in the plurality of DC/DC conversion circuits to decrease.

After the highest temperature value decreases to be less than or equal to a second safety threshold, step S302 is performed.

Step S302: Control a current value of an input current of at least one DC/DC conversion circuit in the plurality of DC/DC conversion circuits to increase.

If the highest temperature value increases to be greater than the second alarm threshold after the current value of the input current of the at least one DC/DC conversion circuit is increased, step S303 is performed.

Step S303: Output a signal indicating that the direct current terminal corresponding to the at least one DC/DC conversion circuit is abnormal.

The second safety threshold is less than or equal to the second alarm threshold.

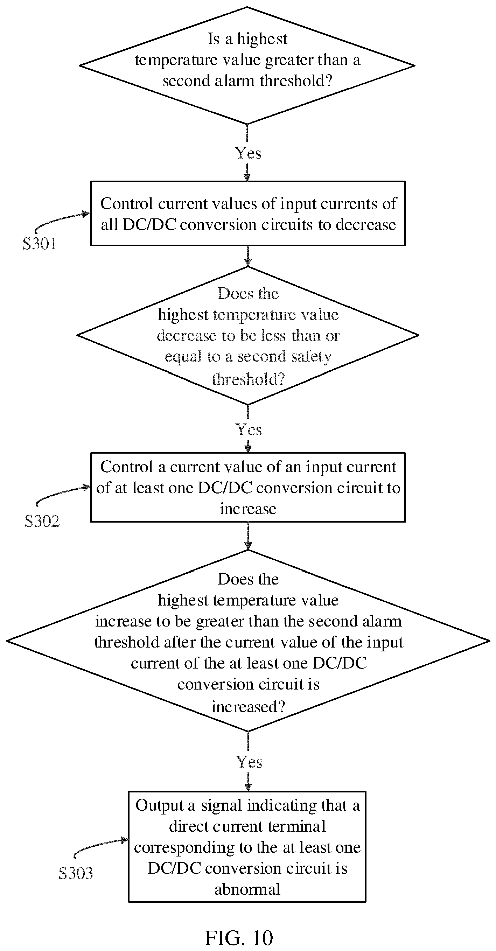

For a process of performing the method in the foregoing embodiment, refer to FIG. 10 in the accompanying drawings of this specification.

In another possible implementation provided in this embodiment of this application, the method includes the following steps.

When a highest temperature value is greater than a second alarm threshold, step S401 is performed.

Step S401: Control current values of input currents of all DC/DC conversion circuits in the plurality of DC/DC conversion circuits to decrease, and after the highest temperature value decreases to be less than or equal to a second safety threshold, perform step S402.

Step S402: Sequentially control the current values of the input currents of the plurality of DC/DC conversion circuits to increase.

If the highest temperature value increases to be greater than the second alarm threshold within a second time threshold existing after a current value of an input current of an m^{th} DC/DC conversion circuit is increased, step S403 is performed.

Step S403: Output a signal indicating that the direct current terminal corresponding to the m^{th} DC/DC conversion circuit is abnormal.

It should be noted that, after the signal indicating that the direct current terminal corresponding to the m^{th} DC/DC conversion circuit is abnormal is output, abnormal terminal detection logic may continue to be performed, or may be stopped. This is not specifically limited in this embodiment of this application.

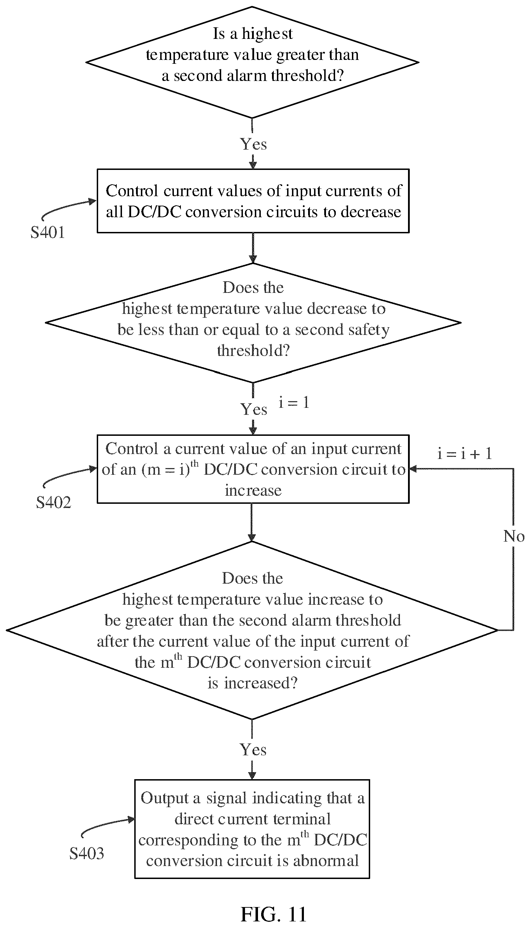

For a process of performing the method in the foregoing embodiment, refer to FIG. 11 in the accompanying drawings of this specification.

It should be understood that, for the foregoing method for detecting an abnormal terminal, reference may be made to determining logic performed by the controller 140 in the power converter 100 provided in this application. For example, one first time threshold condition may be set between performing step S101 and step S102. If the highest temperature value decreases to be less than or equal to the first safety threshold within the first time threshold existing after the current value of the input current of the at least one DC/DC conversion circuit is decreased, determining logic of S102 is performed. If the first time threshold condition is not met, an abnormality determining process for a direct current terminal corresponding to the DC/DC conversion circuit may be stopped, and abnormality determining is performed on a direct current terminal corresponding to another DC/DC conversion circuit.

Further, when S201 is performed, a time interval between decreasing of current values of input currents of two DC/DC conversion circuits may be controlled to be greater than or equal to the first time threshold, so that sufficient time is reserved for the abnormality determining logic. For example, a time interval between a time when a current value of an input current of a q^{th} DC/DC conversion circuit is decreased and a time when a current value of an input current of a (q + 1)^{th} DC/DC conversion circuit is controlled to decrease is greater than or equal to the first time threshold, where 1 ≤ q ≤ n - 1, and q is an integer.

Correspondingly, for performing step S301 to step S303 or performing step S401 to step S403, reference may be made to the determining logic performed by the controller 140 in the power converter 100 provided in this application, as in the case of performing step S101 and step S102 and performing step S201 and step S202. Logic and principles of the steps are basically the same, and details are not described herein again.

It should be noted that when a power converter, including but not limited to the power converter 100 shown in FIG. 4 to FIG. 6 in accompanying drawings of this specification in the foregoing embodiments, further includes a fan, the method for detecting an abnormal terminal in the foregoing embodiment may further be performed in cooperation with rotation speed adjustment of the fan, to achieve an effect of detecting the abnormal terminal more quickly. A detailed method procedure is similar to specific control logic of the controller of the power converter 100 in the foregoing embodiment of this application, and details are not described herein again.

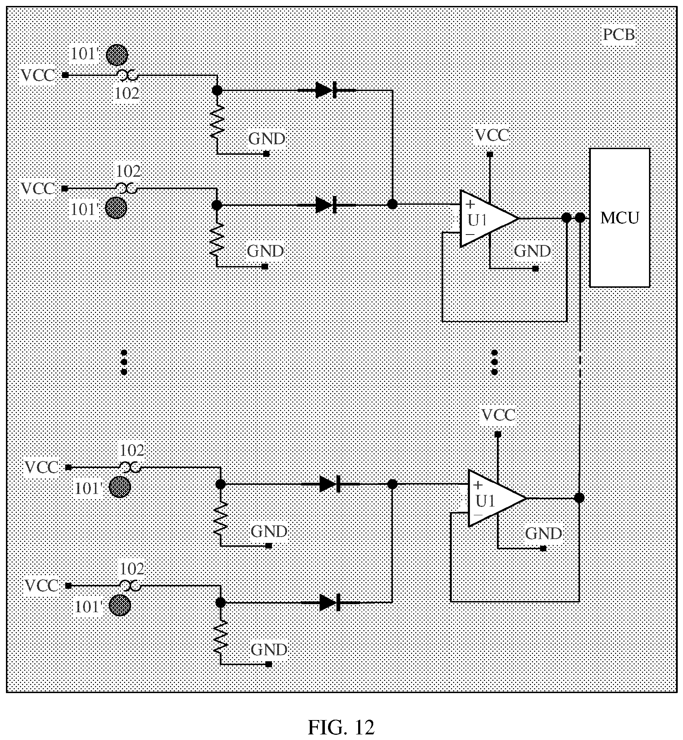

A detection manner of a temperature of a direct current terminal 101 according to an embodiment of this application is shown in FIG. 6 and FIG. 12. A plurality of temperature detection units, a plurality of DC/DC conversion circuits, and at least one DC/AC conversion circuit are incorporated into a PCB inside an inverter 100. Output ends 101' of a plurality of direct current terminals 101 of the inverter 100 are connected to the DC/DC conversion circuits by using the PCB, so that input of electric energy of an external direct current source is implemented.

As shown in FIG. 6, one end of the direct current terminal 101 is on a housing of the inverter 100, the output end 101' of the direct current terminal 101 is inserted into the PCB, and the temperature detection unit includes a plurality of temperature detection branches and operational amplifier circuits. Each temperature detection branch includes one temperature sensing element 102 configured to detect a temperature of the output end 101' of the direct current terminal 101, so that detection of the temperature of the direct current terminal 101 is implemented. The temperature sensing element 102 may be an element whose electrical performance changes with temperature, for example, an NTC or a thermocouple sensor. One end of the temperature sensing element 102 in each temperature detection branch is connected to a corresponding direct current source, the other end of the temperature sensing element 102 is connected to an input end of the operational amplifier circuit, and an output end of the operational amplifier circuit is connected to an input end of a controller. When the temperature of the direct current terminal 101 changes, the temperature of the output end 101' of the direct current terminal 101 changes, a temperature of the temperature sensing element 102 changes, and electrical performance of the temperature sensing element 102 changes, so that an electrical signal received by the operational amplifier circuit changes, an electrical signal received by the controller changes, and finally the controller identifies a temperature situation of the direct current terminal 101.

In an embodiment, still refer to FIG. 6. One end of the direct current terminal 101 is on a housing of the inverter 100, the output end 101' of the direct current terminal 101 is inserted into the PCB, and a temperature sensing element 102 is an NTC. The NTC 102 is placed near the output end 101' of the direct current terminal 101, and is configured to detect a temperature of the output end 101' of the direct current terminal 101. The temperature is approximately a temperature of the direct current terminal 101, and whether the temperature of the direct current terminal 101 is abnormal is determined based on the temperature.

It should be understood that, as a preset power of the inverter 100 increases, the inverter 100 needs more direct current input, a quantity of direct current terminals 101 increases, and more NTCs 102 are needed to perform temperature detection on the direct current terminals 101. For example, in a relatively refined detection requirement, each direct current terminal 101 needs to have one NTC 102 for performing temperature detection on the direct current terminal 101. As shown in FIG. 12, one NTC 102 is placed near each direct current terminal 101.

A specific principle of detecting a temperature by the NTC 102 is that a resistance value of the NTC 102 decreases as a temperature increases, and when a potential at one end of the NTC 102 is fixed, a potential at the other end of the NTC 102 is detected, so that whether the resistance value of the NTC 102 changes can be known, and whether a temperature of the NTC 102 changes may also be known. A temperature of the NTC 102 near the output end 101' of the direct current terminal 101, that is, the temperature of the NTC 102, can be approximately the temperature of the output end 101' of the direct current terminal 101.

Still refer to FIG. 12. One end of each NTC 102 is connected to the direct current source VCC and the other end is grounded by using a voltage divider resistor. A connection point between the NTC 102 and the voltage divider resistor is connected to a positive terminal of a diode, and a negative terminal of the diode is connected to a positive terminal of the operational amplifier circuit. For example, when a voltage of the direct current source VCC is 5 V, a resistance value of the voltage divider resistor is fixed, and the temperature of the direct current terminal 101 is normal, if the resistance value of the NTC 102 is equal to the resistance value of the voltage divider resistor, a potential of the connection point between the NTC 102 and the voltage divider resistor is 2.5 V. When situations, for example, connection to the direct current terminal 101 is loose, occur, the temperature of the direct current terminal 101 increases, the temperature of the NTC 102 increases, the resistance value of the NTC 102 decreases, and the potential of the connection point between the NTC 102 and the voltage divider resistor increases. In this case, the operational amplifier circuit senses that the potential of the connection point between the NTC 102 and the voltage divider resistor increases, and the operational amplifier circuit transmits the information to the controller MCU. When the potential value increases to a preset threshold that is set in advance in the controller MCU, it indicates that the detected temperature of the direct current terminal 101 in the circuit reaches a first alarm threshold, and the controller MCU determines that the direct current terminal 101 detected by the NTC 102 connected to the operational amplifier circuit is abnormal.

Still refer to FIG. 12. In an embodiment, one operational amplifier circuit needs to receive electrical signals transmitted by two NTCs 102. In other words, two temperature detection branches are combined and then connected to a positive terminal of the operational amplifier circuit. Specifically, each of two direct current sources VCCs is connected to one end of each of two NTCs 102 near output ends 101' of direct current terminals 101, and the other end of each of the two NTCs 102 is grounded by using a corresponding voltage divider resistor. Connection points between the two NTCs 102 and the two voltage divider resistors are respectively connected to anodes of two diodes, and cathodes of the two diodes are connected and then connected to the positive terminal of the operational amplifier circuit. Because the diode is only conducted when a potential at the positive terminal is high and a potential at the negative terminal is low, a branch whose potential is higher after the two temperature detection branches transmits the electrical signal to the operational amplifier circuit. In other words, a branch with a direct current terminal 101 whose temperature is higher transmits the electrical signal to the operational amplifier circuit. In this design, detection precision is sacrificed a little, however, use of the operational amplifier circuit can be reduced, and hardware costs can be saved.

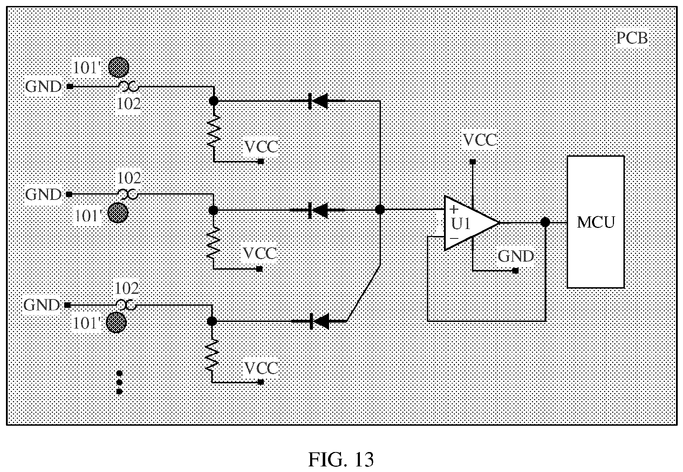

Refer to FIG. 13. When accuracy of temperature detection does not need to be very high, a plurality of temperature detection branches may be combined and then connected to an operational amplifier circuit. Provided that one temperature in temperatures of direct current terminals 101 in the plurality of branches is excessively high, a controller MCU determines that the direct current terminal 101 detected by an NTC 102 connected to the operational amplifier circuit is abnormal.

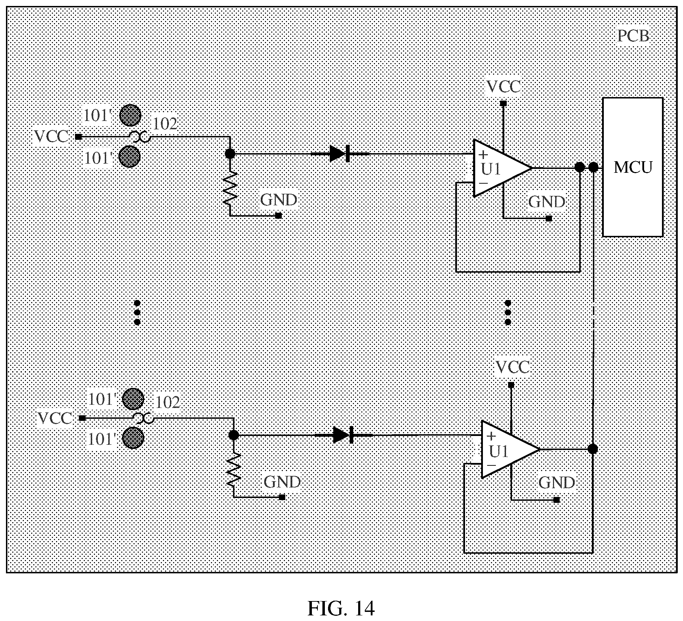

Refer to FIG. 14. In another embodiment, one NTC 102 detects temperatures of output ends 101' of two direct current terminals 101 displaced adjacent to each other simultaneously. This reduces use of the NTC 102 and further saves hardware materials. It should be understood that, inserting positions of output ends 101' of the direct current terminals 101 on a PCB are designed to be adjacent to each other. In this way, the NTC 102 may be closely adjacent to output ends 101' of the two direct current terminals 101. A temperature of the NTC 102 is determined by a temperature of a direct current terminal 101 whose temperature is higher. When a temperature of any one of the direct current terminals 101 is abnormal, that is a detected temperature of the direct current terminal 101 reaches a first alarm threshold, a controller MCU may receive a corresponding signal to give an alarm.

Further, the controller MCU may be a same controller as a controller 140 in an inverter 100. When the controller 140 identifies that a specific direct current terminal 101 is abnormal, or that a terminal in several direct current terminals 101 is abnormal, that is when detected temperatures of one or several direct current terminals 101 reach the first alarm threshold, the controller 140 controls a direct current/direct current conversion circuit 110 correspondingly connected to the direct current terminals 101 and reduce an input current of the direct current/direct current conversion circuit 110, so that a current flowing through the direct current terminals 101 correspondingly connected to the direct current/direct current conversion circuit 110 is reduced, and temperatures of the direct current terminals 101 decrease.

In another possible implementation, when the controller 140 identifies that a specific direct current terminal 101 is abnormal, or a terminal in several direct current terminals 101 is abnormal, that is, when detected temperatures of one or several direct current terminals 101 reach the first alarm threshold, the controller 140 controls the direct current/direct current conversion circuit 110 that is correspondingly connected to the direct current terminals 101 and directly control the direct current/direct current conversion circuit 110 to not work, so that an input current of the direct current/direct current conversion circuit 110 is reduced to 0, a current flowing through the direct current terminals 101 correspondingly connected to the direct current/direct current conversion circuit 110 is 0, and temperatures of the direct current terminals 101 decrease.

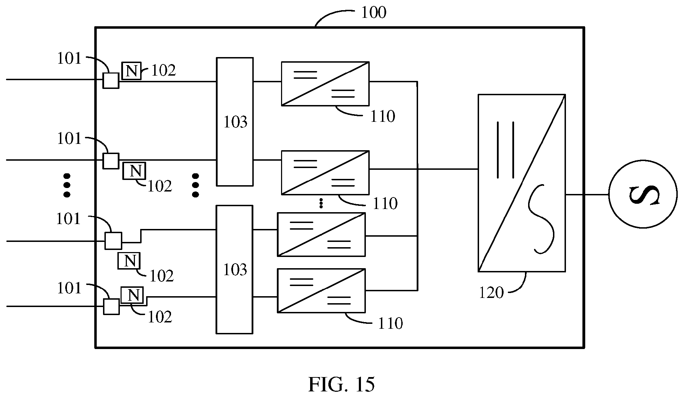

In still another possible implementation, refer to FIG. 15. An inverter 100 includes a plurality of direct current switches 103, and the direct current switch 103 is connected between a direct current terminal 101 and a direct current/direct current conversion circuit 110. The direct current switch 103 is correspondingly connected to two direct current/direct current conversion circuits 110, and each direct current/direct current conversion circuit 110 is correspondingly connected to a direct current input provided by five photovoltaic modules 200. A direct current input provided by each photovoltaic module 200 corresponds to two direct current terminals. In other words, each direct current/direct current conversion circuit 110 corresponds to 10 direct current terminals 101. In this way, the direct current switch 103 can synchronously manage a direct current input provided by the 10 photovoltaic modules 200 corresponding to the two direct current/direct current conversion circuits 110, that is, control electrical connection between 20 direct current terminals 101 and the two direct current/direct current conversion circuits 110. A controller 140 may control turn-on and turn-off of the direct current switch 103. When the controller 140 identifies that a specific direct current terminal 101 is abnormal, or a direct current terminal in several direct current terminals 101 is abnormal, the controller 140 may directly control the direct current switch 103 to be turned off, so that input currents of the two direct current/direct current conversion circuits 110 are reduced to 0, so that currents flowing through the direct current terminals 101 that are correspondingly connected to the two direct current/direct current conversion circuits 110 are 0, and the temperatures of the direct current terminals 101 decrease.

Embodiments of this application are described in detail above. The principle and implementation of this application are described herein by using specific examples. The description of the foregoing embodiments is merely provided to help understand the method and core ideas of this application. In addition, a person of ordinary skill in the art can make variations and modifications to this application in terms of the specific implementations and application scopes according to the ideas of this application without departing from the scope of the appended claims.

## Claims

1. A power converter (100), comprising a plurality of direct current terminals (101), a plurality of direct current/direct current, DC/DC, conversion circuits (110), at least one direct current/alternating current, DC/AC, conversion circuit (120), a printed circuit board, PCB, and a controller (140), wherein
a) input ends of the plurality of direct current terminals (101) are configured to connect to a direct current source, output ends (101') of the plurality of direct current terminals (101) are connected to the PCB at a plurality of connection points (101') respectively, the connection points (101') are correspondingly connected to input ends of the plurality of DC/DC conversion circuits (110) respectively, output ends (101') of the plurality of DC/DC conversion circuits (110) are connected to an input end of the at least one DC/AC conversion circuit (120), and an output end (101') of the at least one DC/AC conversion circuit (120) is configured to connect to a load;
**characterized in that**:
b) the power converter (100) comprises a plurality of temperature detection units (102), wherein each of the plurality of temperature detection units (102) and one or two of the connection points (101') are disposed alternately on the PCB, and the plurality of temperature detection units (102) are configured to detect detected temperatures of the corresponding direct current terminals (101); and
c) the controller (140) is configured to control, in response to that a highest temperature value in the detected temperatures of the plurality of direct current terminals (101) is greater than a first alarm threshold, a current value of an input current of at least one DC/DC conversion circuit (110) in the plurality of DC/DC conversion circuits (110) to decrease;.
wherein in a first case c1), the controller (140) is configured to control, in response to that the highest temperature value in the detected temperatures of the plurality of direct current terminals (101) is greater than the first alarm threshold, the current value of the input current of the at least one DC/DC conversion circuit (110) in the plurality of DC/DC conversion circuits (110) to decrease, and if the highest temperature value decreases to be less than or equal to a first safety threshold after the current value of the input current of the at least one DC/DC conversion circuit (110) is decreased, output a signal indicating that the direct current terminal (101) corresponding to the at least one DC/DC conversion circuit (110) is abnormal, wherein the first safety threshold is less than or equal to the first alarm threshold; or
wherein in a second case c2), the controller (140) is configured to control, in response to that the highest temperature value in the detected temperatures of the plurality of direct current terminals (101) is greater than a second alarm threshold, current values of input currents of all DC/DC conversion circuits (110) in the plurality of DC/DC conversion circuits (110) to decrease, then control, in response to that the highest temperature value decreases to be less than or equal to a second safety threshold, the current value of the input current of the at least one DC/DC conversion circuit (110) in the plurality of DC/DC conversion circuits (110) to increase, and if the highest temperature value increases to be greater than the second alarm threshold after the current value of the input current of the at least one DC/DC conversion circuit (110) is increased, output a signal indicating that a direct current terminal (101) corresponding to the at least one DC/DC conversion circuit (110) is abnormal, wherein the second safety threshold is less than or equal to the second alarm threshold.

2. The power converter (100) according to claim 1, wherein for the first case c1)
the power converter (100) comprises a fan (130); and
the control, in response to that a highest temperature value in the detected temperatures of the plurality of direct current terminals (101) is greater than a first alarm threshold, a current value of an input current of at least one DC/DC conversion circuit (110) in the plurality of DC/DC conversion circuits (110) to decrease comprises:
controlling, in response to that the highest temperature value in the detected temperatures of the plurality of direct current terminals (101) is greater than the first alarm threshold, a rotation speed of the fan (130) to increase, so that the highest temperature value decreases to be less than the first alarm threshold, then controlling the rotation speed of the fan (130) to decrease, and controlling, in response to that the highest temperature value returns to the first alarm threshold, the current value of the input current of the at least one DC/DC conversion circuit (110) in the plurality of DC/DC conversion circuits (110) to decrease.

3. The power converter (100) according to claim 1, wherein for the second case c2):
the power converter (100) comprises a fan (130); and
the control, in response to that the highest temperature value in the detected temperatures of the plurality of direct current terminals (101) is greater than the second alarm threshold, current values of input currents of all the DC/DC conversion circuits (110) in the plurality of DC/DC conversion circuits (110) to decrease comprises:
controlling, in response to that the highest temperature value in the detected temperatures of the plurality of direct current terminals (101) is greater than the second alarm threshold, the current values of the input currents of all the DC/DC conversion circuits (110) in the plurality of DC/DC conversion circuits (110) to decrease, and controlling a rotation speed of the fan (130) to increase.

4. The power converter (100) according to claim 3, wherein
the control, in response to that the highest temperature value decreases to be less than or equal to a second safety threshold, the current value of the input current of the at least one DC/DC conversion circuit (110) in the plurality of DC/DC conversion circuits (110) to increase comprises:
controlling, in response to that the highest temperature value decreases to be less than or equal to the second safety threshold, the rotation speed of the fan (130) to decrease, and then controlling the current value of the input current of the at least one DC/DC conversion circuit (110) in the plurality of DC/DC conversion circuits (110) to increase.

5. The power converter (100) according to claim 1 wherein
the control of a current value of an input current of at least one DC/DC conversion circuit (110) in the plurality of DC/DC conversion circuits (110) to decrease comprises:
sequentially controlling a current value of an input current of a DC/DC conversion circuit (110) in the plurality of DC/DC conversion circuits (110) to decrease.

6. The power converter (100) according to claim 1, wherein
the control of the current value of the input current of the at least one DC/DC conversion circuit (110) in the plurality of DC/DC conversion circuits (110) to increase comprises:
sequentially controlling a current value of an input current of a DC/DC conversion circuit (110) in the plurality of DC/DC conversion circuits (110) to increase.

7. The power converter (100) according to claim 1, wherein
the plurality of temperature detection units (102), the plurality of DC/DC conversion circuits (110), and the at least one DC/AC conversion circuit are integrated into one or more PCBs, the output ends (101') of the plurality of direct current terminals (101) are electrically connected to the DC/DC conversion circuits (110) by using the PCB; the temperature detection unit (102) comprises a plurality of temperature detection branches and a plurality of operational amplifier circuits, and each temperature detection branch comprises a direct current source and a temperature sensing element (102); and the direct current source and the temperature sensing element (102) of each temperature detection branch are connected to each other in a one-to-one correspondence, wherein the direct current source is connected to one end of the temperature sensing element (102), the other end of the temperature sensing element (102) is connected to an input end of the operational amplifier circuit, and an output end (101') of the operational amplifier circuit is connected to a signal input end of the controller (140).

8. The power converter (100) according to claim 7, wherein
the temperature sensing element (102) is an NTC (102), and the temperature detection branch further comprises a voltage divider resistor and a diode; and
the direct current source, the temperature sensing element (102), the voltage divider resistor, and the diode of each temperature detection branch are connected to each other in a one-to-one correspondence, wherein the direct current source is connected to one end of the NTC (102), the other end of the NTC (102) is grounded by using the voltage divider resistor, the other end of the NTC (102) is further connected to a positive electrode of the diode, a negative electrode of the diode is connected to a positive input end of the operational amplifier circuit, and a negative input end of the operational amplifier circuit is connected to the output end (101') of the operational amplifier circuit.

9. The power converter (100) according to claim 8, wherein
the NTC (102) of each temperature detection branch is disposed adjacent to an output end (101') of at least one corresponding direct current terminal (101) in the output ends (101') of the plurality of direct current terminals (101), and the NTC (102) is configured to reduce a resistance value when a temperature of the output end (101') of the at least one corresponding direct current terminal (101) increases, so that a potential value of a connection point (101') between the NTC (102) and the voltage divider resistor increases, and the potential value of the connection point (101') between the NTC (102) and the voltage divider resistor and the temperature of the output end (101') of the direct current terminal (101) are in a one-to-one correspondence, that is, the potential value of the connection point (101') between the NTC (102) and the voltage divider resistor and the detected temperature of the direct current terminal (101) are in a one-to-one correspondence; and
the controller (140) is configured to send an alarm signal when the potential value of the connection point (101') between the NTC (102) and the voltage divider resistor in any one of the temperature detection branches is greater than a preset threshold, that is, when the detected temperature of the direct current terminal (101) is greater than the first alarm threshold.

10. The power converter (100) according to claim 8, wherein
the NTC (102) of each temperature detection branch is disposed adjacent to output ends (101') of two corresponding direct current terminals (101) in the output ends (101') of the plurality of direct current terminals (101), and the NTC (102) is configured to reduce a resistance value when temperatures of the output ends (101') of the two corresponding direct current terminals (101) increase, so that a potential value of a connection point (101') between the NTC (102) and the voltage divider resistor increases.

11. The power converter (100) according to claim 8 or 9, wherein
a negative electrode of the diode of each of the plurality of temperature detection branches is connected to a negative electrode of a diode of a temperature detection branch adjacent to the temperature detection branch.

12. The power converter (100) according to claim 1, comprising a plurality of direct current switches (103), wherein
each direct current switch (103) is connected between a plurality of corresponding direct current terminals (101) and two DC/DC conversion circuits (110) corresponding to the plurality of corresponding direct current terminals (101); and
the controller (140) is configured to control, when a detected temperature of any one of the direct current terminals (101) is greater than the first alarm threshold, the direct current switch (103) connected to the direct current terminal (101) to be turned off.

13. The power converter (100) according to claim 1, wherein
the controller (140) is configured to control, when a detected temperature of any one of the direct current terminals (101) is greater than the first alarm threshold, an input current of the DC/DC conversion circuit (110) that is correspondingly connected to the direct current terminal (101) to decrease; or
the controller (140) is configured to control, when a detected temperature of any one of the direct current terminals (101) is greater than the first alarm threshold, an input current of the DC/DC conversion circuit (110) that is correspondingly connected to the direct current terminal (101) to be 0.

## Patentansprüche

1. Leistungswandler (100), umfassend eine Vielzahl von Gleichstromanschlüssen (101), eine Vielzahl von Gleichstrom-Gleichstrom(DC/DC)-Wandelschaltungen (110), mindestens eine Gleichstrom-Wechselstrom(DC/AC)-Wandelschaltung (120), eine Leiterplatte, PCB, und eine Steuereinrichtung (140), wobei
a) die Eingangsenden der Vielzahl von Gleichstromanschlüssen (101) dazu konfiguriert sind, mit einer Gleichstromquelle verbunden zu werden; die Ausgangsenden (101') der Vielzahl von Gleichstromanschlüssen (101) jeweils an einer Vielzahl von Verbindungspunkten (101') mit der PCB verbunden sind, die Verbindungspunkte (101') jeweils entsprechend mit Eingangsenden der Vielzahl von DC/DC-Wandelschaltungen (110) verbunden sind, Ausgangsenden (101') der Vielzahl von DC/DC-Wandelschaltungen (110) mit einem Eingangsende der mindestens einen DC/AC-Wandelschaltung (120) verbunden sind und ein Ausgangsende (101') der mindestens einen DC/AC-Wandelschaltung (120) dazu konfiguriert ist, mit einer Last verbunden zu werden; **dadurch gekennzeichnet, dass**:
b) der Leistungswandler (100) eine Vielzahl von Temperaturerkennungseinheiten (102) umfasst, wobei jede der Vielzahl von Temperaturerkennungseinheiten (102) und einer oder zwei der Verbindungspunkte (101') abwechselnd auf der PCB angeordnet sind, und die Vielzahl von Temperaturerkennungseinheiten (102) dazu konfiguriert ist, erkannte Temperaturen der entsprechenden Gleichstromanschlüsse (101) zu erkennen; und
c) die Steuereinrichtung (140) dazu konfiguriert ist, als Reaktion darauf, dass ein höchster Temperaturwert unter den erkannten Temperaturen der Vielzahl von Gleichstromanschlüssen (101) größer als eine erste Alarmschwelle ist, einen Stromwert eines Eingangsstroms mindestens einer DC/DC-Wandelschaltung (110) aus der Vielzahl von DC/DC-Wandelschaltungen (110) so zu steuern, dass er abnimmt;.
wobei in einem ersten Fall c1) die Steuereinrichtung (140) dazu konfiguriert ist, als Reaktion darauf, dass der höchste Temperaturwert unter den erkannten Temperaturen der Vielzahl von Gleichstromanschlüssen (101) größer als die erste Alarmschwelle ist, den Stromwert des Eingangsstroms der mindestens einen DC/DC-Wandelschaltung (110) aus der Vielzahl von DC/DC-Wandelschaltungen (110) so zu steuern, dass er abnimmt, und, falls der höchste Temperaturwert nach der Verringerung des Stromwerts des Eingangsstroms der mindestens einen DC/DC-Wandelschaltung (110) so abnimmt, dass er niedriger oder gleich einer ersten Sicherheitsschwelle ist, ein Signal auszugeben, das angibt, dass der der mindestens einen DC/DC-Wandelschaltung (110) entsprechende Gleichstromanschluss (101) anormal ist, wobei die erste Sicherheitsschwelle kleiner oder gleich der ersten Alarmschwelle ist; oder
wobei in einem zweiten Fall c2) die Steuereinrichtung (140) dazu konfiguriert ist, als Reaktion darauf, dass der höchste Temperaturwert unter den erkannten Temperaturen der Vielzahl von Gleichstromanschlüssen (101) größer als eine zweite Alarmschwelle ist, Stromwerte von Eingangsströmen aller DC/DC-Wandelschaltungen (110) aus der Vielzahl von DC/DC-Wandelschaltungen (110) so zu steuern, dass sie abnehmen, dann als Reaktion darauf, dass der höchste Temperaturwert so abnimmt, dass er kleiner oder gleich einer zweiten Sicherheitsschwelle ist, den Stromwert des Eingangsstroms der mindestens einen DC/DC-Wandelschaltung (110) aus der Vielzahl von DC/DC-Wandelschaltungen (110) so zu steuern, dass er zunimmt, und, falls der höchste Temperaturwert nach der Zunahme des Stromwerts des Eingangsstroms der mindestens einen DC/DC-Wandelschaltung (110) so zunimmt, dass er größer als die zweite Alarmschwelle ist, ein Signal auszugeben, das angibt, dass ein Gleichstromanschluss (101), der der mindestens einen DC/DC-Wandelschaltung (110) entspricht, anormal ist, wobei die zweite Sicherheitsschwelle kleiner oder gleich der zweiten Alarmschwelle ist.

2. Leistungswandler (100) nach Anspruch 1, wobei für den ersten Fall c1)
der Leistungswandler (100) einen Lüfter (130) umfasst; und
die Steuerung als Reaktion darauf, dass ein höchster Temperaturwert unter den erkannten Temperaturen der Vielzahl von Gleichstromanschlüssen (101) größer als eine erste Alarmschwelle ist, einen Stromwert eines Eingangsstroms mindestens einer DC/DC-Wandelschaltung (110) aus der Vielzahl von DC/DC-Wandelschaltungen (110), dass er abnimmt, Folgendes umfasst:
Steuern, als Reaktion darauf, dass der höchste Temperaturwert unter den erkannten Temperaturen der Vielzahl von Gleichstromanschlüssen (101) größer als die erste Alarmschwelle ist, einer Drehzahl des Lüfters (130), sodass sie zunimmt, sodass der höchste Temperaturwert so abnimmt, dass er niedriger als die erste Alarmschwelle ist, dann Steuern der Drehzahl des Lüfters (130), sodass sie abnimmt, und als Reaktion darauf, dass der höchste Temperaturwert wieder auf die ersten Alarmschwelle zurückkehrt, Steuern des Stromwerts des Eingangsstroms der mindestens einen DC/DC-Wandelschaltung (110) aus der Vielzahl von DC/DC-Wandelschaltungen (110), sodass er abnimmt.

3. Leistungswandler (100) nach Anspruch 1, wobei für den zweiten Fall c2):
der Leistungswandler (100) einen Lüfter (130) umfasst; und
die Steuerung als Reaktion darauf, dass der höchste Temperaturwert unter den erkannten Temperaturen der Vielzahl von Gleichstromanschlüssen (101) größer als die zweite Alarmschwelle ist, Stromwerte von Eingangsströmen aller DC/DC-Wandelschaltungen (110) aus der Vielzahl von DC/DC-Wandelschaltungen (110), dass sie abnehmen, Folgendes umfasst: Steuern, als Reaktion darauf, dass der höchste Temperaturwert unter den erkannten Temperaturen der Vielzahl von Gleichstromanschlüssen (101) größer als die zweite Alarmschwelle ist, der Stromwerte der Eingangsströme aller DC/DC-Wandelschaltungen (110) aus der Vielzahl von DC/DC-Wandelschaltungen (110), sodass sie abnehmen, und Steuern einer Drehzahl des Lüfters (130), sodass sie zunimmt.

4. Leistungswandler (100) nach Anspruch 3, wobei
die Steuerung, als Reaktion darauf, dass der höchste Temperaturwert abnimmt, sodass er niedriger oder gleich einer zweiten Sicherheitsschwelle ist, den Stromwert des Eingangsstroms der mindestens einen DC/DC-Wandelschaltung (110) aus der Vielzahl von DC/DC-Wandelschaltungen (110), dass er zunimmt, Folgendes umfasst:
Steuern, als Reaktion darauf, dass der höchste Temperaturwert abnimmt, sodass er niedriger oder gleich der zweiten Sicherheitsschwelle ist, der Drehzahl des Lüfters (130), sodass sie abnimmt, und dann Steuern des Stromwerts des Eingangsstroms der mindestens einen DC/DC-Wandelschaltung (110) aus der Vielzahl von DC/DC-Wandelschaltungen (110), sodass er zunimmt.

5. Leistungswandler (100) nach Anspruch 1, wobei
die Steuerung eines Stromwerts eines Eingangsstroms mindestens einer DC/DC-Wandelschaltung (110) aus der Vielzahl von DC/DC-Wandelschaltungen (110), sodass er abnimmt, Folgendes umfasst:
sequentielles Steuern eines Stromwerts eines Eingangsstroms einer DC/DC-Wandelschaltung (110) aus der Vielzahl von DC/DC-Wandelschaltungen (110), sodass er abnimmt.

6. Leistungswandler (100) nach Anspruch 1, wobei
die Steuerung des Stromwerts des Eingangsstroms der mindestens einen DC/DC-Wandelschaltung (110) aus der Vielzahl von DC/DC-Wandelschaltungen (110), sodass er abnimmt, Folgendes umfasst:
sequentielles Steuern eines Stromwerts eines Eingangsstroms einer DC/DC-Wandelschaltung (110) aus der Vielzahl von DC/DC-Wandelschaltungen (110), sodass er zunimmt.

7. Leistungswandler (100) nach Anspruch 1, wobei
die Vielzahl von Temperaturerkennungseinheiten (102), die Vielzahl von DC/DC-Wandelschaltungen (110) und die mindestens eine DC/AC-Wandelschaltung in eine oder mehrere PCBs integriert sind, die Ausgangsenden (101') der Vielzahl von Gleichstromanschlüssen (101) unter Verwendung der PCB elektrisch mit den DC/DC-Wandelschaltungen (110) verbunden sind; die Temperaturerkennungseinheit (102) eine Vielzahl von Temperaturerkennungszweigen und eine Vielzahl von Operationsverstärkerschaltungen umfasst und jeder Temperaturerkennungszweig eine Gleichstromquelle und ein Temperaturerfassungselement (102) umfasst; und die Gleichstromquelle und das Temperaturerfassungselement (102) jedes Temperaturerkennungszweigs in einer Eins-zu-eins-Entsprechung miteinander verbunden sind, wobei die Gleichstromquelle mit einem Ende des Temperaturerfassungselements (102) verbunden ist, das andere Ende des Temperaturerfassungselements (102) mit einem Eingangsende der Operationsverstärkerschaltung verbunden ist und ein Ausgangsende (101') der Operationsverstärkerschaltung mit einem Signaleingangsende der Steuereinrichtung (140) verbunden ist.

8. Leistungswandler (100) nach Anspruch 7, wobei
das Temperaturerfassungselement (102) ein NTC (102) ist und der Temperaturerkennungszweig ferner einen Spannungsteilerwiderstand und eine Diode umfasst; und
die Gleichstromquelle, das Temperaturerfassungselement (102), der Spannungsteilerwiderstand und die Diode jedes Temperaturerkennungszweigs in einer Eins-zu-eins-Entsprechung miteinander verbunden sind, wobei die Gleichstromquelle an einem Ende des NTC (102) verbunden ist, das andere Ende des NTC (102) unter Verwendung des Spannungsteilerwiderstands geerdet ist, das andere Ende des NTC (102) ferner mit einer positiven Elektrode der Diode verbunden ist, eine negative Elektrode der Diode mit einem positiven Eingangsende der Operationsverstärkerschaltung verbunden ist und ein negatives Eingangsende der Operationsverstärkerschaltung mit dem Ausgangsende (101') der Operationsverstärkerschaltung verbunden ist.

9. Leistungswandler (100) nach Anspruch 8, wobei
der NTC (102) jedes Temperaturerkennungszweigs benachbart zu einem Ausgangsende (101') mindestens eines entsprechenden Gleichstromanschlusses (101) unter den Ausgangsenden (101') der Vielzahl von Gleichstromanschlüssen (101) angeordnet ist und der NTC (102) dazu konfiguriert ist, einen Widerstandswert zu verringern, wenn eine Temperatur des Ausgangsendes (101') des mindestens einen entsprechenden Gleichstromanschlusses (101) zunimmt, sodass ein Potentialwert eines Verbindungspunkts (101') zwischen dem NTC (102) und dem Spannungsteilerwiderstand zunimmt, und der Potentialwert des Verbindungspunkts (101') zwischen dem NTC (102) und dem Spannungsteilerwiderstand und die Temperatur des Ausgangsendes (101') des Gleichstromanschlusses (101) in einer Eins-zu-eins-Entsprechung stehen, das heißt, der Potentialwert des Verbindungspunkts (101') zwischen dem NTC (102) und dem Spannungsteilerwiderstand und die erkannte Temperatur des Gleichstromanschlusses (101) in einer Eins-zu-eins-Entsprechung stehen; und
die Steuereinrichtung (140) dazu konfiguriert ist, ein Alarmsignal zu senden, wenn der Potentialwert des Verbindungspunkts (101') zwischen dem NTC (102) und dem Spannungsteilerwiderstand in einem beliebigen der Temperaturerkennungszweige größer als eine voreingestellte Schwelle ist, das heißt, wenn die erkannte Temperatur des Gleichstromanschlusses (101) größer als die erste Alarmschwelle ist.

10. Leistungswandler (100) nach Anspruch 8, wobei
der NTC (102) jedes Temperaturerkennungszweigs benachbart zu Ausgangsenden (101') zweier entsprechender Gleichstromanschlüsse (101) unter den Ausgangsenden (101') der Vielzahl von Gleichstromanschlüssen (101) angeordnet ist und der NTC (102) dazu konfiguriert ist, einen Widerstandswert zu verringern, wenn Temperaturen der Ausgangsenden (101') der zwei entsprechenden Gleichstromanschlüsse (101) zunehmen, sodass ein Potenzialwert eines Verbindungspunktes (101') zwischen dem NTC (102) und dem Spannungsteilerwiderstand zunimmt.

11. Leistungswandler (100) nach Anspruch 8 oder 9, wobei
eine negative Elektrode der Diode jedes der Vielzahl von Temperaturerkennungszweigen mit einer negativen Elektrode einer Diode eines dem Temperaturerkennungszweig benachbarten Temperaturerkennungszweigs verbunden ist.

12. Leistungswandler (100) nach Anspruch 1, umfassend eine Vielzahl von Gleichstromschaltern (103), wobei
jeder Gleichstromschalter (103) zwischen einer Vielzahl entsprechender Gleichstromanschlüsse (101) und zwei DC/DC-Wandelschaltungen (110) verbunden ist, die der Vielzahl von entsprechenden Gleichstromanschlüssen (101) entsprechen; und
die Steuereinrichtung (140) dazu konfiguriert ist, wenn eine erkannte Temperatur eines beliebigen der Gleichstromanschlüsse (101) größer als eine erste Alarmschwelle ist, den mit dem Gleichstromanschluss (101) verbundenen Gleichstromschalter (103) so zu steuern, dass er ausgeschaltet wird.

13. Leistungswandler (100) nach Anspruch 1, wobei
die Steuereinrichtung (140) dazu konfiguriert ist, wenn eine erkannte Temperatur eines beliebigen der Gleichstromanschlüsse (101) größer als die erste Alarmschwelle ist, einen Eingangsstrom der DC/DC-Wandelschaltung (110), die entsprechend mit dem Gleichstromanschluss (101) verbunden ist, so zu steuern, dass er abnimmt; oder
die Steuereinrichtung (140) dazu konfiguriert ist, wenn eine erkannte Temperatur eines beliebigen der Gleichstromanschlüsse (101) größer als die erste Alarmschwelle ist, einen Eingangsstrom der DC/DC-Wandelschaltung (110), die entsprechend mit dem Gleichstromanschluss (101) verbunden ist, so zu steuern, dass er 0 ist.

## Revendications

1. Convertisseur de puissance (100), comprenant une pluralité de bornes de courant continu (101), une pluralité de circuits de conversion courant continu/courant continu, CC/CC, (110), au moins un circuit de conversion courant continu/courant alternatif, CC/CA, (120), une carte de circuit imprimé, PCB, et un contrôleur (140), dans lequel
a) les extrémités d'entrée de la pluralité de bornes de courant continu (101) sont configurées pour être connectées à une source de courant continu, les extrémités de sortie (101') de la pluralité de bornes de courant continu (101) sont respectivement connectées à la PCB au niveau d'une pluralité de points de connexion (101'), les points de connexion (101') sont respectivement connectés en correspondance aux extrémités d'entrée de la pluralité de circuits de conversion CC/CC (110), les extrémités de sortie (101') de la pluralité de circuits de conversion CC/CC (110) sont connectées à une extrémité d'entrée de l'au moins un circuit de conversion CC/CA (120), et une extrémité de sortie (101') de l'au moins un circuit de conversion CC/CA (120) est configurée pour être connectée à une charge ; **caractérisé en ce que** :
b) le convertisseur de puissance (100) comprend une pluralité d'unités de détection de température (102), dans lequel chacune de la pluralité d'unités de détection de température (102) et un ou deux des points de connexion (101') sont disposés alternativement sur la PCB, et la pluralité d'unités de détection de température (102) sont configurées pour détecter les températures détectées des bornes de courant continu correspondantes (101) ; et
c) le contrôleur (140) est configuré pour commander, en réponse au fait qu'une valeur de température la plus élevée parmi les températures détectées de la pluralité de bornes de courant continu (101) est supérieure à un premier seuil d'alarme, une diminution d'une valeur de courant d'un courant d'entrée d'au moins un circuit de conversion CC/CC (110) parmi la pluralité de circuits de conversion CC/CC (110) ;.
dans lequel dans un premier cas c1), le contrôleur (140) est configuré pour commander, en réponse au fait que la valeur de température la plus élevée parmi les températures détectées de la pluralité de bornes de courant continu (101) est supérieure au premier seuil d'alarme, une diminution de la valeur de courant du courant d'entrée de l'au moins un circuit de conversion CC/CC (110) parmi la pluralité de circuits de conversion CC/CC (110), et si la valeur de température la plus élevée diminue pour être inférieure ou égale à un premier seuil de sécurité après la diminution de la valeur de courant du courant d'entrée de l'au moins un circuit de conversion CC/CC (110), émettre un signal indiquant que la borne de courant continu (101) correspondant à l'au moins un circuit de conversion CC/CC (110) est anormale, dans lequel le premier seuil de sécurité étant inférieur ou égal au premier seuil d'alarme ; ou
dans lequel dans un second cas c2), le contrôleur (140) est configuré pour commander, en réponse au fait que la valeur de température la plus élevée parmi les températures détectées de la pluralité de bornes de courant continu (101) est supérieure à un second seuil d'alarme, une diminution de valeurs de courant de courants d'entrée de tous les circuits de conversion CC/CC (110) parmi la pluralité de circuits de conversion CC/CC (110), puis pour commander, en réponse au fait que la valeur de température la plus élevée diminue pour être inférieure ou égale à un second seuil de sécurité, une augmentation de la valeur de courant du courant d'entrée de l'au moins un circuit de conversion CC/CC (110) parmi la pluralité de circuits de conversion CC/CC (110), et si la valeur de température la plus élevée augmente pour être supérieure au second seuil d'alarme après l'augmentation de la valeur de courant du courant d'entrée de l'au moins un circuit de conversion CC/CC (110), émettre un signal indiquant qu'une borne de courant continu (101) correspondant à l'au moins un circuit de conversion CC/CC (110) est anormale, dans lequel le second seuil de sécurité est inférieur ou égal au second seuil d'alarme.

2. Convertisseur de puissance (100) selon la revendication 1, dans lequel, pour le premier cas c1)
le convertisseur de puissance (100) comprend un ventilateur (130) ; et
la commande, en réponse au fait qu'une valeur de température la plus élevée parmi les températures détectées de la pluralité de bornes de courant continu (101) est supérieure à un premier seuil d'alarme, d'une diminution d'une valeur de courant d'un courant d'entrée d'au moins un circuit de conversion CC/CC (110) parmi la pluralité de circuits de conversion CC/CC (110) comprend :
la commande, en réponse au fait que la valeur de température la plus élevée parmi les températures détectées de la pluralité de bornes de courant continu (101) est supérieure au premier seuil d'alarme, d'une augmentation d'une vitesse de rotation du ventilateur (130), de sorte que la valeur de température la plus élevée diminue pour être inférieure au premier seuil d'alarme, puis la commande d'une diminution de la vitesse de rotation du ventilateur (130), et la commande, en réponse au fait que la valeur de température la plus élevée revient au premier seuil d'alarme, d'une diminution d'une valeur de courant du courant d'entrée de l'au moins un circuit de conversion CC/CC (110) parmi la pluralité de circuits de conversion CC/CC (110).

3. Convertisseur de puissance (100) selon la revendication 1, dans lequel, pour le second cas c2) :
le convertisseur de puissance (100) comprend un ventilateur (130) ; et
la commande, en réponse au fait que la valeur de température la plus élevée parmi les températures détectées de la pluralité de bornes de courant continu (101) est supérieure au second seuil d'alarme, d'une diminution de valeurs de courant de courants d'entrée de tous les circuits de conversion CC/CC (110) parmi la pluralité de circuits de conversion CC/CC (110) comprend : la commande, en réponse au fait que la valeur de température la plus élevée parmi les températures détectées de la pluralité de bornes de courant continu (101) est supérieure au second seuil d'alarme, d'une diminution de valeurs de courant des courants d'entrée de tous les circuits de conversion CC/CC (110) parmi la pluralité de circuits de conversion CC/CC (110) et la commande d'une augmentation d'une vitesse de rotation du ventilateur (130).

4. Convertisseur de puissance (100) selon la revendication 3, dans lequel
la commande, en réponse au fait que la valeur de température la plus élevée diminue pour être inférieure ou égale à un second seuil de sécurité, d'une augmentation de la valeur de courant du courant d'entrée de l'au moins un circuit de conversion CC/CC (110) parmi la pluralité de circuits de conversion CC/CC (110) comprend :
la commande, en réponse au fait que la valeur de température la plus élevée diminue pour être inférieure ou égale au second seuil de sécurité, d'une diminution de la vitesse de rotation du ventilateur (130), puis la commande d'une augmentation de la valeur de courant du courant d'entrée de l'au moins un circuit de conversion CC/CC (110) parmi la pluralité de circuits de conversion CC/CC (110).

5. Convertisseur de puissance (100) selon la revendication 1, dans lequel
la commande d'une diminution d'une valeur de courant d'un courant d'entrée d'au moins un circuit de conversion CC/CC (110) parmi la pluralité de circuits de conversion CC/CC (110) comprend :
la commande séquentielle d'une diminution d'une valeur de courant d'un courant d'entrée d'un circuit de conversion CC/CC (110) parmi la pluralité de circuits de conversion CC/CC (110).

6. Convertisseur de puissance (100) selon la revendication 1, dans lequel
la commande d'une augmentation de la valeur de courant du courant d'entrée de l'au moins un circuit de conversion CC/CC (110) parmi la pluralité de circuits de conversion CC/CC (110) comprend :
la commande séquentielle d'une augmentation d'une valeur de courant d'un courant d'entrée d'un circuit de conversion CC/CC (110) parmi la pluralité de circuits de conversion CC/CC (110).

7. Convertisseur de puissance (100) selon la revendication 1, dans lequel
la pluralité d'unités de détection de température (102), la pluralité de circuits de conversion CC/CC (110) et l'au moins un circuit de conversion CC/CA sont intégrés dans une ou plusieurs PCB, les extrémités de sortie (101') de la pluralité de bornes de courant continu (101) sont connectées électriquement aux circuits de conversion CC/CC (110) à l'aide de la PCB ; l'unité de détection de température (102) comprend une pluralité de branches de détection de température et une pluralité de circuits amplificateurs opérationnels, et chaque branche de détection de température comprend une source de courant continu et un élément de détection de température (102) ; et la source de courant continu et l'élément de détection de température (102) de chaque branche de détection de température sont connectés l'un à l'autre selon une correspondance biunivoque, dans lequel la source de courant continu est connectée à une extrémité de l'élément de détection de température (102), l'autre extrémité de l'élément de détection de température (102) est connectée à une extrémité d'entrée du circuit amplificateur opérationnel, et une extrémité de sortie (101') du circuit amplificateur opérationnel est connectée à une extrémité d'entrée de signal du contrôleur (140).

8. Convertisseur de puissance (100) selon la revendication 7, dans lequel
l'élément de détection de température (102) est un NTC (102), et la branche de détection de température comprend en outre une résistance diviseuse de tension et une diode ; et
la source de courant continu, l'élément de détection de température (102), la résistance diviseuse de tension et la diode de chaque branche de détection de température sont connectés les uns aux autres selon une correspondance biunivoque, dans lequel la source de courant continu est connectée à une extrémité du NTC (102), l'autre extrémité du NTC (102) est mise à la terre à l'aide de la résistance diviseuse de tension, l'autre extrémité du NTC (102) est en outre connectée à une électrode positive de la diode, une électrode négative de la diode est connectée à une extrémité d'entrée positive du circuit amplificateur opérationnel, et une extrémité d'entrée négative du circuit amplificateur opérationnel est connectée à l'extrémité de sortie (101') du circuit amplificateur opérationnel.

9. Convertisseur de puissance (100) selon la revendication 8, dans lequel
le NTC (102) de chaque branche de détection de température est disposé adjacent à une extrémité de sortie (101') d'au moins une borne de courant continu correspondante (101) parmi les extrémités de sortie (101') de la pluralité de bornes de courant continu (101), et le NTC (102) est configuré pour réduire une valeur de résistance lorsqu'une température de l'extrémité de sortie (101') de l'au moins une borne de courant continu correspondante (101) augmente, de sorte qu'une valeur de potentiel d'un point de connexion (101') entre le NTC (102) et la résistance diviseuse de tension augmente, et la valeur de potentiel du point de connexion (101') entre le NTC (102) et la résistance diviseuse de tension et la température de l'extrémité de sortie (101') de la borne de courant continu (101) sont en correspondance biunivoque, c'est-à-dire que la valeur de potentiel du point de connexion (101') entre le NTC (102) et la résistance diviseuse de tension et la température détectée de la borne de courant continu (101) sont en correspondance biunivoque ; et
le contrôleur (140) est configuré pour envoyer un signal d'alarme lorsque la valeur de potentiel du point de connexion (101') entre le NTC (102) et la résistance diviseuse de tension dans l'une quelconque des branches de détection de température est supérieure à un seuil prédéfini, c'est-à-dire lorsque la température détectée de la borne de courant continu (101) est supérieure au premier seuil d'alarme.

10. Convertisseur de puissance (100) selon la revendication 8, dans lequel
le NTC (102) de chaque branche de détection de température est disposé adjacent aux extrémités de sortie (101') de deux bornes de courant continu correspondantes (101) dans les extrémités de sortie (101') de la pluralité de bornes de courant continu (101), et le NTC (102) est configuré pour réduire une valeur de résistance lorsque les températures des extrémités de sortie (101') des deux bornes de courant continu correspondantes (101) augmentent, de sorte qu'une valeur de potentiel d'un point de connexion (101') entre le NTC (102) et la résistance diviseuse de tension augmente.

11. Convertisseur de puissance (100) selon la revendication 8 ou 9, dans lequel
une électrode négative de la diode de chacune de la pluralité de branches de détection de température est connectée à une électrode négative d'une diode d'une branche de détection de température adjacente à la branche de détection de température.

12. Convertisseur de puissance (100) selon la revendication 1, comprenant une pluralité de commutateurs de courant continu (103), dans lequel
chaque commutateur de courant continu (103) est connecté entre une pluralité de bornes de courant continu correspondantes (101) et deux circuits de conversion CC/CC (110) correspondant à la pluralité de bornes de courant continu correspondantes (101) ; et
le contrôleur (140) est configuré pour commander, lorsqu'une température détectée de l'une quelconque des bornes de courant continu (101) est supérieure au premier seuil d'alarme, la désactivation du commutateur de courant continu (103) connecté à la borne de courant continu (101).

13. Convertisseur de puissance (100) selon la revendication 1, dans lequel
le contrôleur (140) est configuré pour commander, lorsqu'une température détectée de l'une quelconque des bornes de courant continu (101) est supérieure au premier seuil d'alarme, une diminution d'un courant d'entrée du circuit de conversion CC/CC (110) qui est connecté en correspondance à la borne de courant continu (101) ; ou
le contrôleur (140) est configuré pour commander, lorsqu'une température détectée de l'une quelconque des bornes de courant continu (101) est supérieure au premier seuil d'alarme, un courant d'entrée du circuit de conversion CC/CC (110) qui est connecté en correspondance à la borne de courant continu (101) pour être 0.
